# EUROPEAN PATENT APPLICATION

(11) **EP 4 811 945 A1**
(43) Date of publication of application: **23.09.2026**
(21) Application number: 26164911.5
(22) Date of filing: 16.03.2026
(51) Int. Cl.: H05K 7/20, H10W 40/47

(54) **COOLING APPARATUS AROUND CENTRAL REGION**

(30) Priority: 16.03.2025 US 202519080895
(71) Applicant: Mellanox Technologies, Ltd., 2069200 Yokneam (IL)
(72) Inventor: GUREVICH, Shalom Alexander, 2069200 Yokneam (IL); DANTUS, Ari, 2069200 Yokneam (IL); BEN JOSEPH, Dikla Lidya, 2069200 Yokneam (IL); ALTMAN, Talia, 2069200 Yokneam (IL); BECKER, Rom, 2069200 Yokneam (IL); ZARETSKY, Shay, 2069200 Yokneam (IL)
(74) Representative: Mathys & Squire

(57) **Abstract**

A system for circulating cooling liquid in a circular path around a central region of an apparatus. An apparatus may receive cooling fluid through a manifold, circulate the cooling fluid in a circular path around a central region, circulate the cooling fluid into the central region, then discharge the cooling fluid.

## Description

### BACKGROUND

Cooling systems are often used in hardware environments to dissipate heat from the one or more heat-generating elements like CPUs, GPUs, and other processors. Some cooling systems use cooling loops to circulate cooling liquid proximate to these heat-generating elements. However, some of these components may be difficult to reach due to limited space. For example, placing a cooling element (e.g., a cold plate) and a cooling loop near a heat-generating component may require multiple apparatuses which may lead to inefficiency, upkeep, and time-consuming handling.

### SUMMARY

The invention is defined by the claims. In order to illustrate the invention, aspects and embodiments which may or may not fall within the scope of the claims are described herein.

A system for circulating cooling liquid in a circular path around a central region of an apparatus. An apparatus may receive cooling fluid through a manifold, circulate the cooling fluid in a circular path around a central region, circulate the cooling fluid into the central region, then discharge the cooling fluid.

Any feature of one aspect or embodiment may be applied to other aspects or embodiments, in any appropriate combination. In particular, any feature of a method aspect or embodiment may be applied to an apparatus aspect or embodiment, and vice versa.

### BRIEF DESCRIPTION OF THE DRAWINGS

Various embodiments in accordance with the present disclosure will be described with reference to the drawings, in which:
FIG. 1 illustrates a system for dissipating heat from one or more heat-generating elements via a cooling loop according to example embodiments;
FIG. 2A illustrates an apparatus including one or more cooling loops for dissipating heat from one or more heat-generating elements according to example embodiments;
FIG. 2B illustrates an apparatus including one or more cooling loops for dissipating heat from one or more heat-generating elements according to example embodiments;
FIG. 2C illustrates one or more plunging elements for allowing an apparatus to engage with a heat-generating element according to example embodiments;
FIG. 2D illustrates a bottom-perspective of an apparatus including one or more cooling loops for dissipating heat from one or more heat-generating elements according to example embodiments;
FIG. 3A illustrates a top-down cross-sectional perspective of an apparatus including a first cooling loop for dissipating heat from one or more heat-generating elements according to example embodiments;
FIG. 3B illustrates a top-down cross-sectional perspective of an apparatus including a first cooling loop and second cooling loop for dissipating heat from one or more heat-generating elements according to example embodiments;
FIG. 3C illustrates a top-down cross-sectional perspective of an apparatus including a cooling loop for dissipating heat from one or more heat-generating elements according to example embodiments;
FIG. 4 illustrates a system for generating temperature information from one or more heat-generating elements and adjusting a flow rate of a cooling loop according to example embodiments;
FIG. 5A illustrates a process for dissipating heat from one or more heat-generating elements according to example embodiments;
FIG. 5B illustrates a process for generating temperature information from one or more heat-generating elements and adjusting a flow rate of a cooling loop according to example embodiments;
FIG. 6 illustrates components of a distributed system that may be utilized in a data center according to example embodiments;
FIG. 7 illustrates an example data center system according to example embodiments;
FIG. 8 illustrates an example computing environment according to example embodiments;
FIG. 9 illustrates a computer system according to example embodiments;
FIG. 10 illustrates a computing system according to example embodiments;
FIG. 11 illustrates an optoelectronic component according to example embodiments;
FIG. 12 illustrates an optoelectronic component according to example embodiments;
FIG. 13 illustrates an optoelectronic component with a substrate and integrated circuit according to example embodiments;
FIG. 14 illustrates an optoelectronic component in a transceiver according to example embodiments; and
FIG. 15 illustrates a networking device according to example embodiments.

### DETAILED DESCRIPTION

In the following description, various embodiments will be described. For purposes of explanation, specific configurations and details are set forth in order to provide a thorough understanding of the embodiments. However, it will also be apparent to one skilled in the art that the embodiments may be practiced without the specific details. Furthermore, well-known features may be omitted or simplified in order not to obscure the embodiment being described.

In conventional cooling environments, cooling loops and cold plates are often used to dissipate heat from heat-generating components. However, the space around these components is usually limited due to the physical constraints of hardware and data center environments. Because of these limitations, some cooling systems do not allow for cold plates with multiple components to be placed in thermal connection with the heat-generating components. As a nonlimiting example, such environments would not allow a cold plate with multiple thermal coupling components around a heat-generating component such as a processor.

This disclosure is directed to an apparatus with one or more cooling loops to circulate cooling liquid proximate to one or more heat-generating elements and cooling elements. In some embodiments, the apparatus is a cold plate with a circular flow of liquid cooling around heat-generating elements, which then moves inside the cold plate. The path of the liquid is circular and goes inside the main silicon. The circular flow increases the liquid volume allowing for more efficient cooling of components. The circular flow ensures that all components remain relatively in the same temperature delta, improving cooling efficiency. This configuration overcomes spatial limitation, specifically tight spaces that do not allow separated cold plates. The use of different thermal interface materials, such as phase-changing material for the main silicon and thermal pads for other components, enables to overcome the spatial limitations.

The apparatus may include two regions: a central region, and a circular region which goes around the central region. The circular region may be proximate one or more heat-generating elements (e.g., just above or otherwise physically proximate the heat-generating elements) or thermal pads in thermal contact with the heat-generating elements. The central region may also be proximate one or more heat-generating elements, and it may include a cooling element such as one or more cold plates. The circular region and the central region may be separated by a wall or other separating element. A first cooling loop may circulate cooling liquid through the circular region to dissipate heat from the heat-generating elements. The one or more heat-generating elements may be positioned around the perimeter of the central region.

In some embodiments, a second cooling loop may receive the cooling liquid from the first cooling loop and circulate the cooling liquid into the central region and proximate to the cooling element (e.g., cold plate). The cooling liquid may be discharged from the apparatus into a manifold or cooling distribution unit. By incorporating two distinct regions and cooling loops within one apparatus, the apparatus described may simplify cooling environments and reduce downtime in assembling cooling systems. The second cooling loop may be positioned within the central region.

In other embodiments, the circular region may also be referred to as a surrounding region, a circumferential region, a cyclic region, a perimeter region, and enclosing region, or any similar description indicating that the circular region goes around the circular region of the apparatus. Furthermore, the region surrounding the central region may be shaped other than circular, such as a general square, rectangle, oval, triangle, or other similar shape for circulating cooling liquid around a central region of the apparatus.

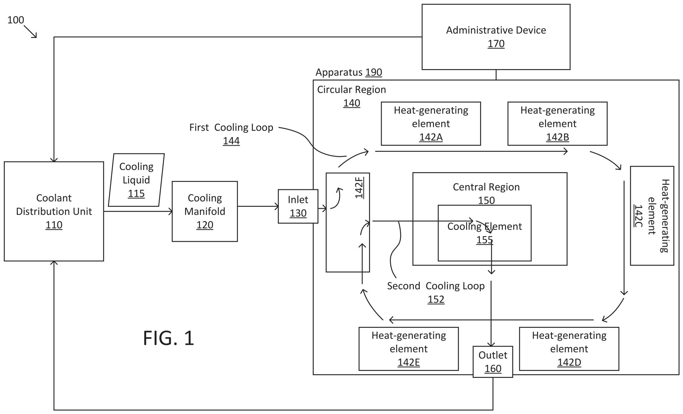

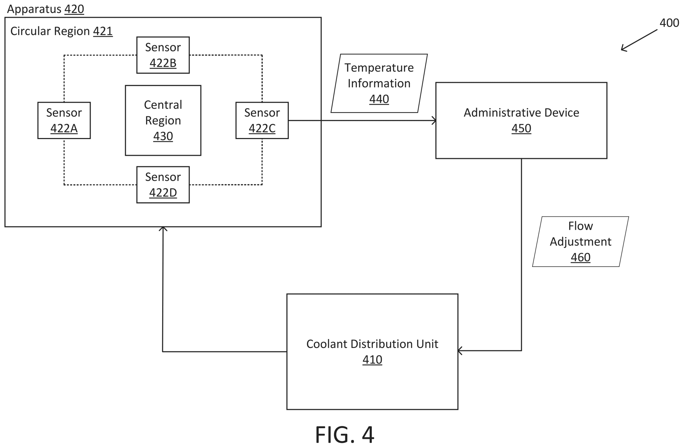

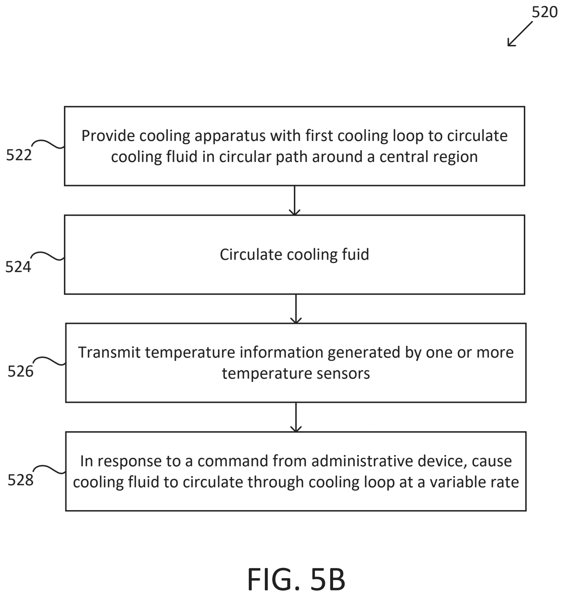

FIG. 1 illustrates a system 100 for circulating cooling liquid into an apparatus 190 including at least a first cooling loop 144 in a circular region 140 around a central region 150 of the apparatus 190. The system 100 may be utilized in a number of cooling environments such as data centers, server racks, high performance computing environments or any other environments in which hardware or heat-generating elements may be stored or used. The system 100 may include a coolant distribution unit (CDU) 110, a cooling manifold 120, an inlet 130, an apparatus 190, an outlet 160, and an administrative device 170. The CDU 110 may circulate cooling liquid 115 into a cooling manifold 120 and into an inlet 130 operably connected or removably attached to the apparatus 190. The apparatus 190 may include at least a first cooling loop 144 and a second cooling loop 152 to circulate the cooling liquid 115 through a circular region 140 and central region 150. The cooling liquid 115 may be circulated proximate to one or more heat-generating components in a circular or serial flow pattern. The cooling liquid 115 may then be discharged through the outlet 160 and optionally back into the CDU 110. The apparatus 190 may be operably connected to the administrative device 170 over a wired or wireless connection. The apparatus 190 may include one or more temperature sensors (not illustrated in FIG. 1 but discussed with further reference to FIGS. 4 and 5B) which may generate and transmit temperature information to the administrative device 170. The administrative device 170 may generate, based at least on this temperature information, a command or query to adjust or vary the flow rate of the cooling liquid 115 through the cooling manifold 120 and apparatus 190.

Generally, the CDU 110 may include machinery and hardware designed to circulate cooling liquid 115 through the cooling manifold 120. The cooling liquid 115 may include water, water-glycol mixture, dielectric fluids (e.g., mineral oil, synthetic fluids, esters) or other suitable fluids. The CDU 110 may circulate the cooling liquid 115 to absorb or dissipate heat from these heat-generating elements 142A-142F, thereby stabilizing temperatures and preventing overheating of the heat-generating elements 142A-142F. In some example embodiments, the CDU 110 may operate using a refrigeration cycle, which involves a compressor which compresses refrigerant gas, allowing it to absorb heat from the cooling liquid, thus cooling the cooling liquid 115 before it is circulated back to the cooling manifold 120 and apparatus 190. Additionally, the CDU 110 may include control systems which monitor the temperature of the cooling liquid 115 and adjust the cooling output as needed to maintain desired temperature levels.

The cooling manifold 120 may include a manifold system designed to facilitate the distribution and routing of the cooling liquid 115 from the CDU 110 to various components within the system 100 including the apparatus 190. The cooling manifold 120 may be a central hub which connects cooling loops leading to the apparatus 190, allowing for efficient cooling liquid 115 flow and temperature regulation across different areas of the system 100. Although FIG. 1 illustrates the cooling manifold 120 connecting to only one apparatus 190, it is understood that in other example embodiments the cooling manifold 120 may connect to multiple apparatuses or indeed other cooling or heat-generating elements in the system 100. In example embodiments, the cooling manifold 120 may be constructed from materials such as durable plastics, aluminum, or other metals or composites.
The apparatus 190 may receive the cooling liquid 115 from the cooling manifold 120 through an inlet 130, and the apparatus may discharge the cooling liquid 115 through an outlet 160. The inlet 130 and outlet 160 may be operably connected or removably attached to the apparatus 190 via one or more connecting elements (e.g., screws, fasteners, or snaps) and corresponding connecting holes to secure the apparatus 190 to the one or more heat-generating elements. The inlet 130 and outlet 160 may be designed to connect with one or more tubes, tubing, loops, hoses, or other apparatuses for circulating the cooling liquid 115. In some example embodiments, the inlet 130 and outlet 160 may have a quick-disconnect (QD) design allowing tubes to be quickly attached and detached from the inlet 130 and outlet 160. In other embodiments, the tubes may be screws or snapped into place on the inlet 130 and outlet 160.

The apparatus 190 may circulate the cooling liquid 115 from the inlet 130 into a first cooling loop 144 which is in a circular region 140 surrounding a central region 150. Generally, the apparatus 190 may have a ring-like or annular structure. The apparatus 190 may have an outer circular area (i.e., the circular region 140) surrounding an area within the outer circular area (i.e., the central region 150). In other embodiments, the apparatus 190 may be concentric, with an outer concentric region (i.e., the circular region 140) and an inner concentric region (i.e., the central region 150). The central region 150 is separated from the circular region 140 by one or more separating elements such as a wall or divider between the central region 150 and circular region 140 (as described elsewhere herein, the second cooling loop 152 connects the central region 150 to circular region by going over the wall or separating element).

The circular region 140 may circulate the cooling liquid 115 through the first cooling loop 144 proximate to one or more heat-generating elements 142A-142F. The heat-generating elements 142A-142F may be proximate to the first cooling loop 144, e.g., the heat-generating elements 142A-142F may be just below the apparatus 190. In some example embodiments, the heat-generating elements 142A-142F may include thermal pads integrated into the apparatus 190 which are in thermal contact with a CPU, GPU, or other heat-generating element. That is, each of the heat-generating element 142A-142F may correspond to one or more separate heat-generating elements or one or more portions of a heat-generating element. As the first cooling loop 144 circulates the cooling liquid 115 near the heat-generating elements 142A-142F, heat is dissipated from the heat-generating elements 142A-142F. The heat-generating elements 142A-142F may include without limitation processor (e.g., a central processing unit (CPU) or graphics processing unit (GPU)), data processing units (DPUs), quantum processing units (QPUs), a plurality of parallel processing units (PPUs), and application-specific integrated circuits (ASICs) memory module, or power supply.

The second cooling loop 152 may receive the cooling liquid 115 from the first cooling loop 144 and circulate the cooling liquid 115 into the central region 150. The second cooling loop 152 may rise above the circular region 140 and over the separating element or wall between the circular region 140 and central region 150. The central region 150 may include a cooling element 155 such as a cold plate which is in thermal contact with a heat-generating element. After being circulated into the central region 150, the cooling liquid 115 may be discharged through the outlet 160 and optionally back into the CDU 110.

In at least one example embodiment, a cold plate may include adjustable fins forming microchannels for fluid to flow through. In at least one embodiment, fins in a cold plate enable transfer of heat from at least one associated computing device to a fluid flowing through microchannels formed between multiple fins. In at least one embodiment, fins of a cold plate are dynamically and adjustable in real time to allow transfer of more heat from at least one computing device to a fluid that flows through a cold plate having fins. In at least one embodiment, such fins may be adjusted by a processor or processorless system based in part on a temperature determined, such as sensed, for a cold plate. In at least one embodiment, a temperature may be associated with at least one computing device, a workload of at least one computing device, or a fluid at different time periods and at an entry, and at an egress of a cold plate. In at least one embodiment, a processorless system may rely on a thermal property of at least two materials used to form fins for a cold plate so that such fins may react without a processor to cause exposure of more surface area to a fluid. In at least one embodiment, such fins may include an overlapping portion that may be caused to be exposed by action of a control mechanism or by properties of at least two materials associated together to form a fin.

Although not illustrated in FIG. 1, the apparatus 190 may also include one or more temperature sensors configured to determine or generate temperature information regarding the heat-generating elements 142A-142F. This temperature information may be transmitted over a wired or wireless connection to the administrative device 170. The administrative device 170 may receive this temperature information and transmit one or more commands or queries to the CDU 110 to change, vary, or adjust the flow rate of the cooling liquid 115 through the cooling manifold 120 and the apparatus 190. The administrative device 170 may include a processor (e.g., a central processing unit (CPU) or graphics processing unit (GPU)), data processing units (DPUs), quantum processing units (QPUs), a plurality of parallel processing units (PPUs), and application-specific integrated circuits (ASICs) memory module, or power supply. QPUs configured to perform one or more operations associated with a quantum algorithm. In some embodiments, each of the one or more QPUs may include a plurality of qubits and the one or more QPUs may be in communication with each other via a quantum channel. In some embodiments, each of the plurality of qubits may include local qubits, global qubits, and/or synchronization qubits. In some embodiments, the local qubits of each QPU may be configured to perform the one or more operations associated with the quantum algorithm on the QPU that the local qubits are associated with.

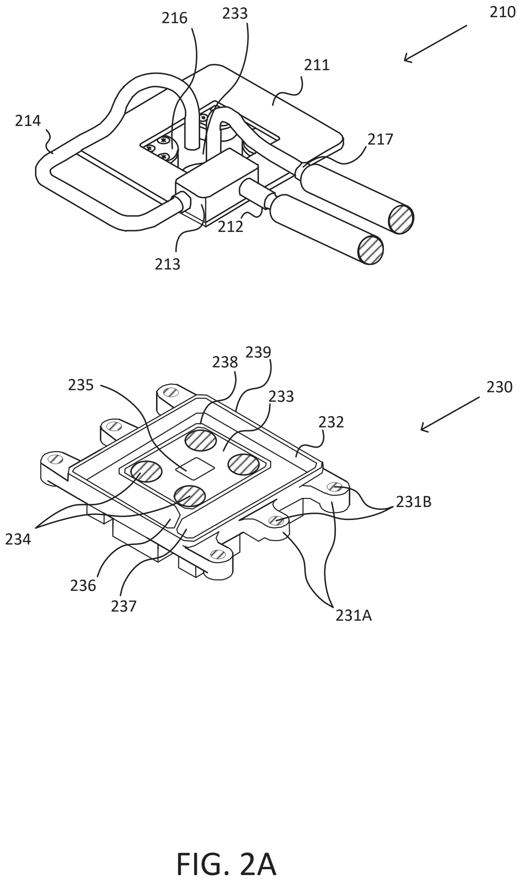

FIG. 2A illustrates an apparatus 240 for circulating cooling liquid. The apparatus 240 may include a top portion 210 and a bottom portion 230. Although FIG. 2A illustrates the apparatus according to certain dimensions, it is understood that in other example embodiments, the elements of the apparatus may vary. As discussed elsewhere herein, in other example embodiments the apparatus 240 may be shaped generally as a square, rectangle, circle, oval, triangle, or any other shape suitable for the circular region 232 and the central region 233.

The bottom portion 230 of the apparatus may include a circular region 232 surrounding a central region 233. In some embodiments, the circular region 232 may itself comprise a cooling loop to circulate cooling liquid in a path (e.g., cyclic) around the central region 233. In other embodiments, the cooling loop may comprise of a separate tubing or hose. The circular region 232 may be a path that is recessed and surrounded by an inner wall 238 and an outer wall 239. The inner wall 238 may separate the circular region 232 and the central region 233. The exterior side of the inner wall 238 and the interior side of the outer wall 239 may define the circular region 232. The interior side of the inner wall 238 may define the circular region 233. The exterior side of the outer wall 239 may define the exterior of the bottom portion 230.

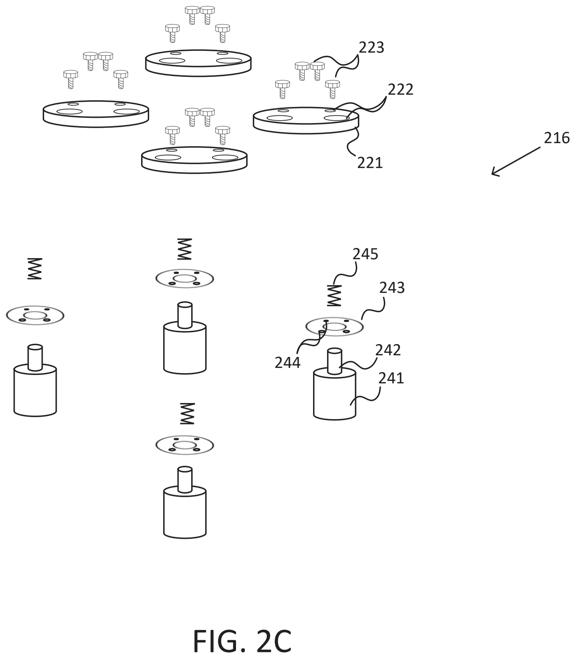

The circular path 232 may begin at an entry point 236, and it may end at terminal point 237. As discussed with further reference to FIG. 1, FIG. 2D, and FIGS. 3A-3B, the circular path 232 may be proximate to one or more heat-generating elements or thermal pads. In some example embodiments, the heat-generating elements may be below the bottom portion 230 when the apparatus 240 is removably attached to such heat-generating elements. Within the central region 233, there may be one or more cooling elements 235 such as one or more cold plates. The cooling region 233 may also have one or more plunger connecting holes 234 to connect the apparatus to one or more plunging elements 216 discussed with further reference to FIG. 2C. The bottom portion 230 may also include one or more mounting tabs 231A each of which include a mounting hole 231B. The mounting holes 231B may allow the apparatus to be connected to a receiving apparatus via one or more connecting elements such as screws or fasteners or ties. Although FIG. 2C illustrates only a certain number of mounting tabs, it is understood that in other example embodiments the apparatus may include a greater or fewer number of mounting tabs 231A.

The top portion 210 may include a cover 211 to cover or span the circular region 232 defined by the inner wall 238 and outer wall 239. The cover 211 may removably attach to the bottom portion via one or more connecting elements. In other example embodiments, the cover 211 may snap into place or snugly fit into a receiving groove on the bottom portion 230. The cover 211 may be ring-shaped or annular, similar to the shape of the circular region 232. In example embodiments, the cover 211 may be comprised of metal, plastic, or composite materials. On or near the cover 211, there may be a manifold 213 to receive cooling liquid through an inlet and receiving element 212. The manifold 213 may be removably attached to the cover 211 by one or more connecting elements such as screws, fasteners, snaps, or other suitable connecting elements. As illustrated, the manifold 213 may be proximate one or more sections of the cover 211 such as one of the corners of the cover 211, though in other example embodiments the manifold 213 may be proximate other areas of the cover 211 such as a different corner of the cover 211 or some portion of the cover 211 that is offset from a corner.

The cooling liquid may circulate from the receiving element 212 into the manifold 213 and into the circular region 232 at the entry point 236. The receiving element 212 may be removably attached to a cooling tube, hose, or manifold. Once the cooling liquid circulates through the circular region 232 and reaches the termination point 237, the cooling liquid may be circulated into the manifold 213 and into the second cooling loop 214 which circulates the cooling liquid into the central region 233. As illustrated in FIG. 2A, the second cooling loop 214 may go over and or around the inner wall 238 and outer wall 239 of the bottom portion 230 to reach the central region 233. Once the cooling liquid circulates through the central region 233, the cooling liquid may be discharged through the outlet element 217 and optionally back into a CDU or manifold. The outlet element 217 may be removably attached to a cooling tube, hose, or manifold.

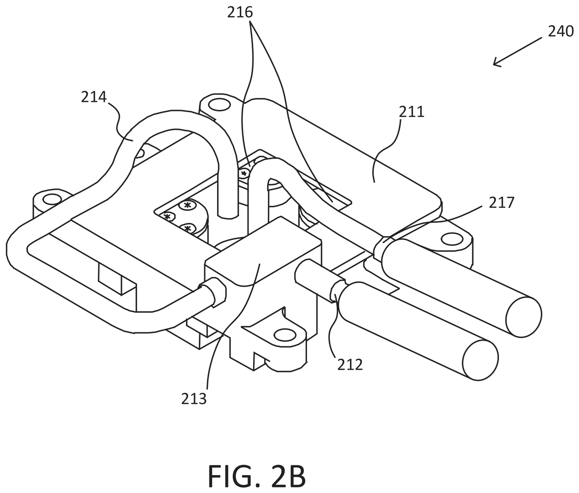

FIG. 2B illustrates the apparatus 240 including the top portion 210 and bottom portion 230 operably connected together. In some example embodiments, the top portion 210 and bottom portion 230 may be separated after being operably connected together. In other example embodiments, the apparatus 240 may be attached to a heat-generating element or a housing proximate to a heat-generating element via the connecting holes 231B. That is, a screw or connecting element may be threaded through the connecting holes 231B and through corresponding holes on a housing of a heat-generating element. As described with further reference to FIGS. 2C-2D, as the apparatus 240 is connected to a receiving apparatus via the connecting holes 231B, the spring mechanism 245 may allow compliance (allowing for different planes and tolerance ranges) between the apparatus 240 and the receiving apparatus such that as the cooling element 256 is pressed against the receiving apparatus, the cooling element 256 may comply via the springs mechanism 245.

FIG. 2C illustrates plunging elements 216 according to one or more example embodiments. Each of the plunging elements may include a cap 221, spring mechanism 245, a base plate 243, a plunging element (such as a plunger head) 242, and a plunger housing 241. In the apparatus 240, the plunging elements 216 may be placed in between the cover 211 and the cooling element 256 such that when the apparatus 240 is attached to a receiving apparatus, the plunging elements 216 may compress and allow the cooling element 256 to move along the axis of the plunging elements 216. In some example embodiments, the plunging elements 216 may give the cooling element 256 enough clearance to sit flush with the thermal elements 258.

Each plunging element 216 may include one or more caps 221. Each cap may comprise one or more receiving holes 222 which may be threaded through by one or more connecting elements 223 such as screws or bolts. The connecting elements 223 maybe screwed into the base plate 243 complete with one or more receiving holes 244 aligning with the receiving holes 222. The plunger head 242 may be engaged in the plunger housing 241. Each spring mechanism 245 may be operably connected with the plunger head 242 so that the plunger head 242 may move within a predetermined clearance within the plunger housing 241. The plunger housing 241 may be in operable connection with the cooling element 256 so that when the cooling element 256 is pushed against a receiving object (e.g., a receiving apparatus), the spring mechanism 245 will be loaded and the cooling element 256 will comply with the receiving object or receiving apparatus. In some example embodiments, the spring mechanism 245 will apply force to the cooling element 256, thereby applying compressive force to the heat-generating elements. In some example embodiments, the heat-generating elements (or the housing of the heat-generating elements) may thermally expand due to high temperatures. When this expansion occurs, the springs mechanism 245 may allow the cooling element 256 to comply with this expansion.

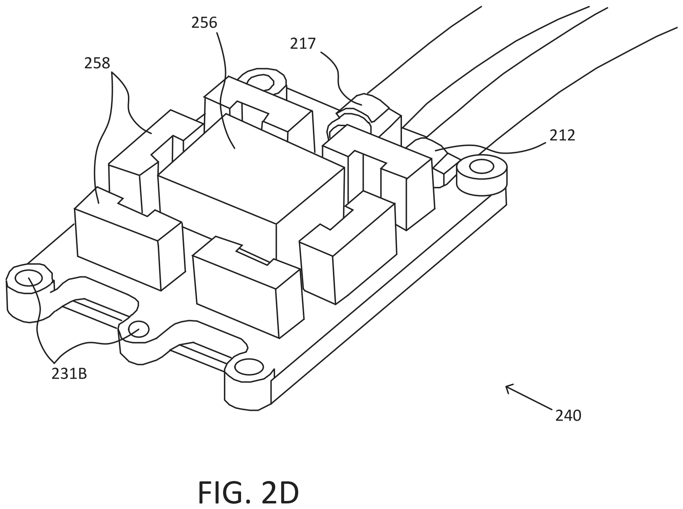

FIG. 2D illustrates a bottom perspective view of the apparatus 240. The bottom of the apparatus 240 may include a cooling element 256 and one or more thermal elements 258. In example embodiments, the cooling element 256 and thermal elements 258 would be in thermal contact with one or more heat-generating elements on a receiving apparatus. As a nonlimiting example, the thermal elements 258 may include thermal pads in thermal contact with CPUs, GPUs, or other processing units. The thermal pads may be made of materials such as silicone or graphite, which have high thermal conductivity. The thermal pads may operate by filling the gaps between the heat-generating elements and the heat sinks, thereby improving heat transfer efficiency. The cooling element 256 may include a cold plate. As illustrated in FIGS. 1-2B, the thermal elements 256 may be below or physically proximate to the circular region 232 with the first cooling loop. The cooling element is below or physically proximate to the central region 233. The apparatus 240 may be operably connected or removably attached to one or more heat-generating elements via the mounting holes 231B.

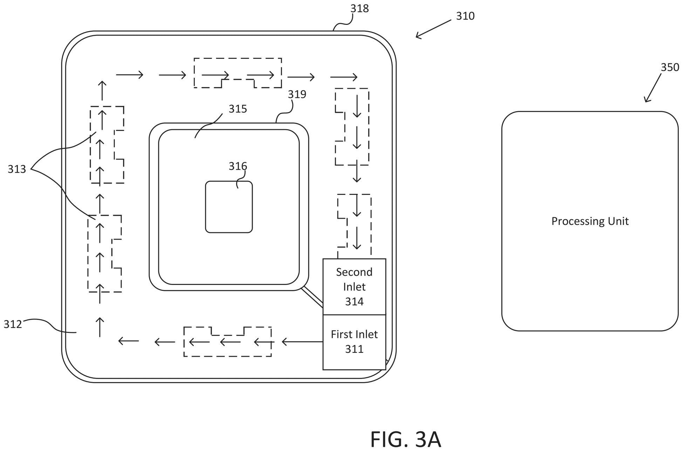

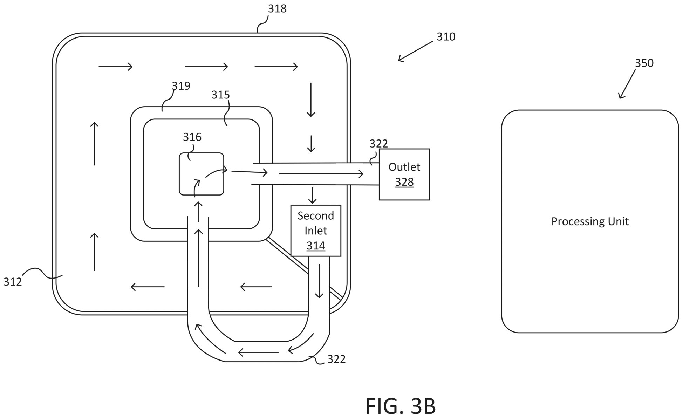

FIG. 3A illustrates a top-down cross-sectional perspective of an apparatus 310 with a circular region 312 and a central region 315. The circular region 312 may surround the central region 315 and circulate cooling liquid proximate to one or more heat-generating elements 313 (six in the present example) which may be, in some example embodiments, below the circular region 312. As discussed elsewhere herein, the circular region 312 may be defined by an outer wall 318 and an inner wall 319. The circular region 312 may act as a first cooling loop for cooling liquid circulated into the apparatus by the first inlet 311. The cooling liquid may be circulated through the first cooling loop around the circular region 312. At the end of the first cooling loop in the circular region 312, the cooling liquid may enter a second inlet 314 which, as discussed with further reference to the manifold 213, circulate the cooling liquid into a second cooling loop 322 which may circulate the cooling liquid over or around the outer wall 318 and inner wall 319. Referring to FIG. 3B, the cooling liquid may be circulated into the second cooling loop 322 by the second inlet 314. The second loop 322 may circulate the cooling liquid into the central region 315 containing a cooling element such as a cold plate 316. The cooling liquid may run proximate to the cold plate 316 and may be discharged via the outlet 328. FIG. 3A and FIG. 3B also illustrate a processing unit 350 that, in some example embodiments, produces heat in the course of its operation. The apparatus 310 may be placed proximate or on top of the processing unit 350 in order to dissipate heat from the processing unit 350. Although FIGS. 3A-3B illustrates only one processing unit 350 of a certain size, in other example embodiments, the apparatus 310 and processing unit 350 may be sized such that multiple processing units 350 may be in thermal contact with the apparatus 310. The processing unit 350 may include, without limitation, one or more CPUs, GPUs, DPUs, QPUs, a plurality of PPUs, one or more ASICs, or a power supply.

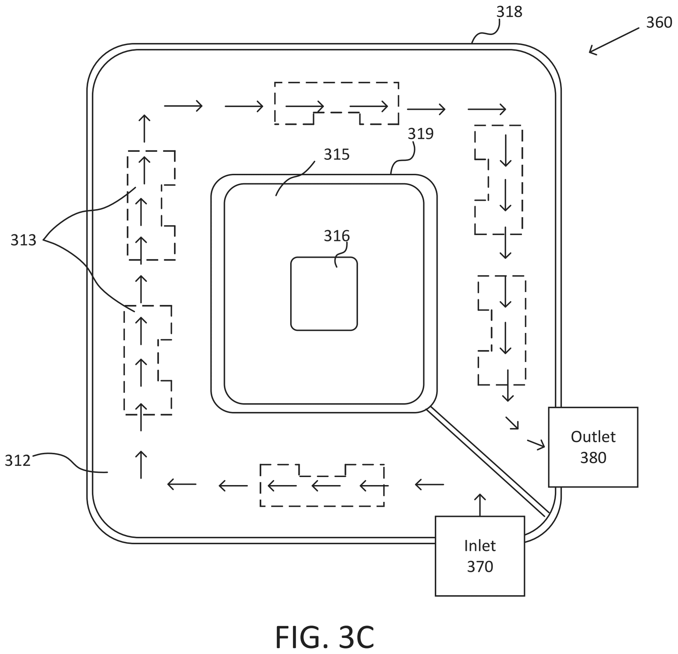

In some example embodiments, the apparatus 360 may include only a single cooling loop. FIG. 3C illustrates a top-down cross-sectional perspective of an apparatus 360 with a circular region 312 and a central region 315. The circular region 312 may surround the central region 315 and circulate cooling liquid proximate to one or more heat-generating elements 313 (six in the present example) which may be, in some example embodiments, below the circular region 312. As discussed elsewhere herein, the circular region 312 may be defined by an outer wall 318 and an inner wall 319. The circular region 312 may act as a cooling loop for cooling liquid circulated into the apparatus by the inlet 370. The cooling liquid may be circulated through the cooling loop around the circular region 312 via the inlet 370. At the end of the cooling loop in the circular region 312, the cooling liquid may be discharged by the outlet 380. In some example embodiments, the cooling liquid may be discharged from the outlet to a CDU.

FIG. 4 illustrates a system 400 for gathering temperature information from an apparatus. The system 400 may include a CDU 410, an apparatus 420, and an administrative device 450. The CDU 410 may include machinery designed to circulate cooling liquid through a cooling manifold connecting the CDU 410 to the apparatus 420. The cooling liquid may include water, water-glycol mixture, dielectric fluids or other suitable fluids. The CDU 410 may circulate the cooling liquid to absorb or dissipate heat from these heat-generating elements, thereby stabilizing temperatures and preventing overheating of the heat-generating elements. In some example embodiments, the CDU 410 may operate using a refrigeration cycle, which involves a compressor which compresses refrigerant gas, allowing it to absorb heat from the water, thus cooling the fluid before it is circulated back to the cooling manifold and apparatus 420. Additionally, the CDU 410 may include control systems which monitor the temperature of the cooling liquid and adjust the cooling output as needed to maintain desired temperature levels. Furthermore, the CDU 410 may adjust or vary the flow of the cooling liquid according to one or more commands, prompts, or queries from the administrative device 450.

The apparatus 420 may include a circular region 421 surrounding a central region 430 as discussed with further reference to FIGS. 1-3B. The apparatus 420 may also include one or more temperature sensors 422A, 422B, 422C, and 422D. The temperature sensors 422A-422D may include may transmit one or more temperature information to the administrative device 450. The apparatus 420 and associated temperature sensors 422A-422D may be connected to the administrative device 450 through one or more wired or wireless connections. In example embodiments, these temperature sensors 422A-422D may determine that one or more heat-generating elements associated with apparatus 420 may be approaching a threshold value such as a threshold for overheating. In response to this data, the administrative device 450 350 may communicate with the CDU 410 to circulate cooling liquid into the apparatus 420. Once cooling liquid is circulating throughout the apparatus 420, the temperature sensors 422A-422D may send updated temperature information to the administrative device 450 which may determine that the temperature of the heat-generating elements is below a threshold level (e.g., 70 degrees Celsius) for suitable operation of the heat-generating elements. In some example embodiments, the administrative device 450 generates and transmits a flow adjustment 460 which may vary the flow rate of the cooling liquid according to the temperature information 440. As a nonlimiting example, the flow rate of the cooling liquid may be defined as the volume of cooling liquid that passes through a specific point in the first cooling loop or second cooling loop per unit of time, e.g., liters per minute (L/min). If the temperature sensors 422A-422D detect that the temperature of the heat-generating elements is rising above the desired threshold, the administrative device 450 may increase the flow rate of the coolant by adjusting the speed of the pump that circulates the cooling liquid. Conversely, if the temperature is below the threshold, the administrative device may reduce the flow rate to conserve energy and maintain optimal operating conditions.

In example embodiments, the temperature sensors 422A-422D may generate temperature information and transmit it to the administrative device 450 and/or a user device, which may then utilize this temperature data to adjust the cooling liquid flow in the cooling loop or make determinations about the overall cooling strategy for the system 400. The temperature sensors 422A-422D may include thermocouples or thermistors, which work by measuring the electrical resistance or voltage changes that occur in response to temperature variations. The temperature sensors 422A-422D may gather temperature information by being placed in direct contact with the surface of the apparatus 420 or in proximity to the heat-generating elements, allowing them to accurately gather temperature information regarding to the heat-generating elements.

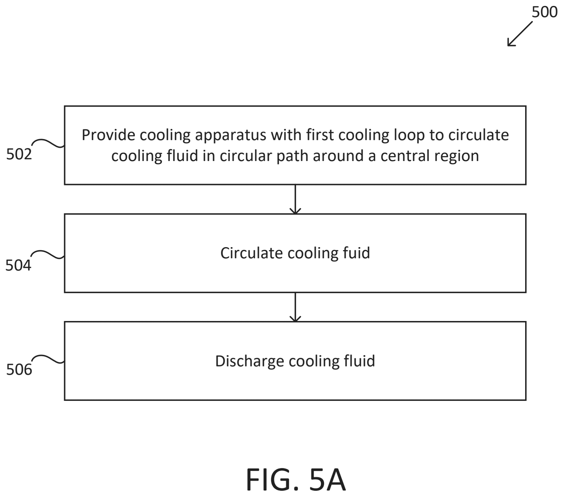

FIG. 5A illustrates a process 500 for dissipating heat from a one or more heat-generating elements. The process 500 may be implemented in various environments discussed elsewhere herein, including without limitation a data center, a server rack, or any other similar environment in which heat-generating elements are cooled. It should be appreciated that steps for the method may be performed in any order, or in parallel, unless otherwise specifically stated. Moreover, the method may include more or fewer steps.

A cooling apparatus with a first cooling loop to circulate cooling liquid in a circular path around a central region is provided 502. Cooling liquid may be circulated 504 through the first cooling loop proximate to one or more heat-generating elements. The cooling loops may transport the cooling liquid throughout the apparatus or proximate one or more heat-generating elements to discharge 506 heat from the heat-generating elements which are in thermal contact with the apparatus.

FIG. 5B illustrates a process 520 for transmitting temperature sensor information to an administrative device. An apparatus may include one or more temperature sensors to generate temperature information regarding the one or more heat-generating elements. For example, the temperature sensors may generate temperature information indicating that one or more areas proximate to the heat-generating elements are reading 70 degrees Celsius or 160 degrees Fahrenheit. It should be appreciated that steps for the method may be performed in any order, or in parallel, unless otherwise specifically stated. Moreover, the method may include more or fewer steps.

A cooling apparatus with a first cooling loop to circulate cooling liquid in a circular path around a central region is provided 522. Cooling liquid may be circulated 524 through the first cooling loop proximate to one or more heat-generating elements. The cooling loops may transport the cooling liquid throughout the apparatus or proximate one or more heat-generating elements to dissipate heat from the heat-generating elements which are in thermal contact with the apparatus.

One or more temperature sensors on the apparatus may generate temperature information and transmit 526 the information to a controller, user device, administrative device, or other suitable device. The information may be transmitted over a wired or wireless connection. The administrative device may receive the temperature information and, upon determining that the temperature information indicates that the temperature corresponding to the one or more heat-generating elements has reached a threshold, command a CDU to circulate cooling liquid to the cold plate. In response to the command from the controller, cooling liquid may be circulated 528 through the first cooling loop and second cooling loop. The cooling loops may transport the cooling liquid throughout the apparatus or proximate one or more heat-generating elements to dissipate heat from the heat-generating elements.

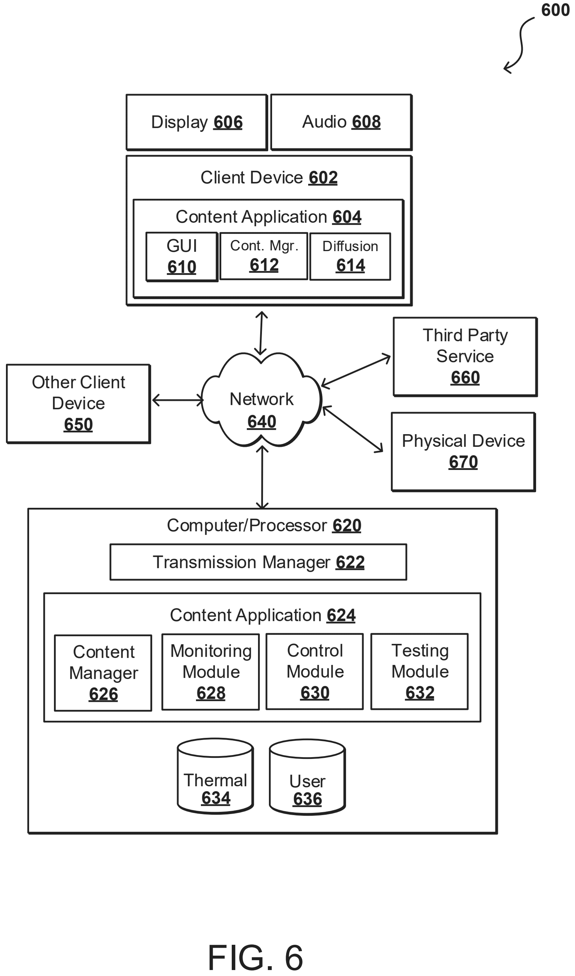

FIG. 6 illustrates an example network configuration 600 of components that can be used to implement aspects of various embodiments, such as to provide, generate, modify, encode, process, fuse, and/or transmit generated image data, calculated measurements, or other such content. In at least one embodiment, a client device 602 can generate or receive data for a session using components of a content application 604 on the client device 602 and data stored locally on that client device. In at least one embodiment, a content application 624 executing on a computer or processor 620 (e.g., a cloud server or control system) may initiate a session associated with at least one client device 602 (e.g., a vehicle or robot), as may use a session manager and user data stored in a user database 636, and can cause content such as liquid coolant or server thermal data to be selected and/or retrieved from a repository 634 to be used by a testing module 632 to calculate one or more performance metrics for a monitoring module 628, which can provide flow data or thermal data to a control module 630 to control a flow or temperature, in an environment where the data is to be used to determine appropriate operation. A content manager 626 may work with at least these various modules to perform testing and analysis, and potentially instruct any actions to be taken in response to a performance metric failing to satisfy an operational requirement. At least a portion of this data or instructional content can be transmitted to the client device 602 and/or a physical device 670 using an appropriate transmission manager 622 to send by download, streaming, or another such transmission channel. An encoder may be used to encode and/or compress at least some of this data before transmitting to the client device 602. In at least one embodiment, the client device 602 receiving such content can provide this content to a corresponding content application 604, which may also or alternatively include a graphical user interface 610, a flow monitor module 612, and a control module 614 for use in providing, synthesizing, rendering, compositing, modifying, or using content for presentation, navigation, control, (or other purposes) on or by the client device 602, such as may be transmitted to the physical device 670. In some embodiments, the computer or processor 620 and client device 602 may be able to communicate directly without needing to transmit data over a network 640, in order to avoid issues with latency and availability, etc. A decoder may also be used to decode data received over the network 640 for presentation via client device 602, such as imaging content or performance metrics through a display device 606 and audio, such as corresponding sounds or synthesized speech, through at least one audio playback device 608, such as speakers or headphones. In at least one embodiment, at least some of this content may already be stored on, rendered on, or accessible to client device 602 such that transmission over a network 640 is not required for at least that portion of content, such as where that content (e.g., thermal data) may have been previously downloaded or stored locally on a hard drive or optical disk. In at least one embodiment, a transmission mechanism such as data streaming can be used to transfer this content from the computer or processor 620, or user database 636, to the client device 602. In at least one embodiment, at least a portion of this content can be obtained, enhanced, and/or streamed from another source, such as a third party service 660 or other client device 650, that may also include a content application for generating, updating, enhancing, or providing map content. In at least one embodiment, portions of this functionality can be performed using multiple computing devices, or multiple processors within one or more computing devices, such as may include a combination of CPUs and GPUs (Graphics Processing Unit), DPUs, QPUs, a plurality of parallel processing units (PPUs).

In this example, these client devices can include any appropriate computing devices, as may include a desktop computer, notebook computer, set-top box, streaming device, gaming console, smartphone, tablet computer, VR headset, AR goggles, wearable computer, or a smart television. Each client device can submit a request across at least one wired or wireless network, as may include the Internet, an Ethernet, a local area network (LAN), or a cellular network, among other such options. In this example, these requests can be submitted to an address associated with a cloud provider, who may operate or control one or more electronic resources in a cloud provider environment, such as may include a data center or server farm. In at least one embodiment, the request may be received or processed by at least one edge server, which sits on a network edge and is outside at least one security layer associated with the cloud provider environment. In this way, latency can be reduced by enabling the client devices to interact with servers that are in closer proximity, while also improving security of resources in the cloud provider environment.

In at least one embodiment, such a system can be used for performing graphical rendering operations. In other embodiments, such a system can be used for other purposes, such as for providing image or video content to test or validate autonomous machine applications, or for performing deep learning operations. In at least one embodiment, such a system can be implemented using an edge device, or may incorporate one or more Virtual Machines (VMs). In at least one embodiment, such a system can be implemented at least partially in a data center or at least partially using cloud computing resources.

### DATA CENTER

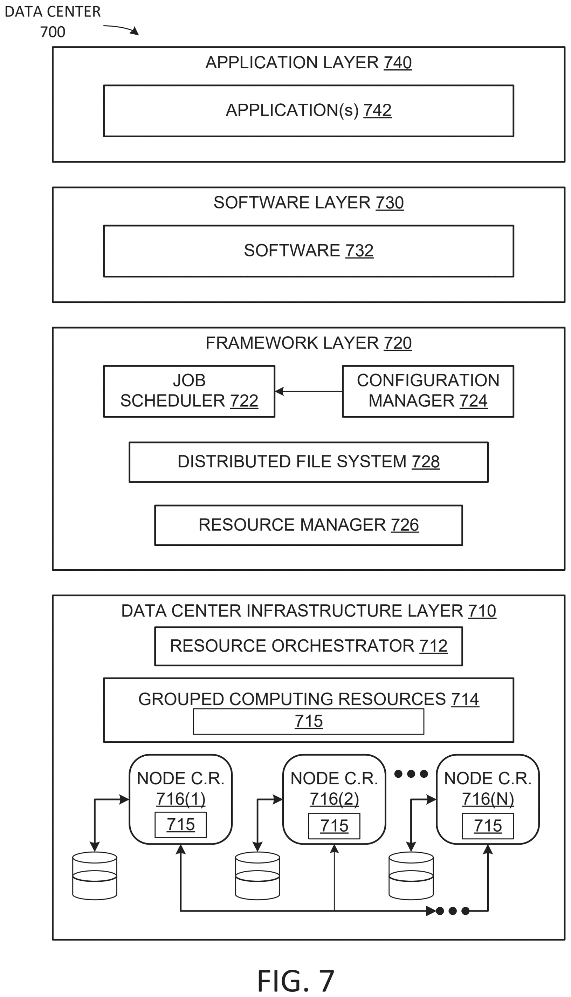

FIG. 7 illustrates an example data center 700, in which at least one embodiment may be used. In at least one embodiment, data center 700 includes a data center infrastructure layer 710, a framework layer 720, a software layer 730, and an application layer 740.

In at least one embodiment, as shown in FIG. 7, data center infrastructure layer 710 may include a resource orchestrator 712, grouped computing resources 714, and node computing resources ("node C.R.s") 716(1)-716(N), where "N" represents any whole, positive integer. In at least one embodiment, node C.R.s 716(1)-716(N) may include, but are not limited to, any number of central processing units ("CPUs") or other processors (including accelerators, field programmable gate arrays (FPGAs), graphics processors, etc.), memory devices (e.g., dynamic read-only memory), storage devices (e.g., solid state or disk drives), network input/output ("NW I/O") devices, network switches, virtual machines ("VMs"), power modules, and cooling modules, etc. In at least one embodiment, one or more node C.R.s from among node C.R.s 716(1)-716(N) may be a server having one or more of above-mentioned computing resources.

In at least one embodiment, grouped computing resources 714 may include separate groupings of node C.R.s housed within one or more racks (not shown), or many racks housed in data centers at various geographical locations (also not shown). Separate groupings of node C.R.s within grouped computing resources 714 may include grouped compute, network, memory or storage resources that may be configured or allocated to support one or more workloads. In at least one embodiment, several node C.R.s including CPUs or processors may grouped within one or more racks to provide compute resources to support one or more workloads. In at least one embodiment, one or more racks may also include any number of power modules, cooling modules, and network switches, in any combination.

In at least one embodiment, resource orchestrator 712 may configure or otherwise control one or more node C.R.s 716(1)-716(N) and/or grouped computing resources 714. In at least one embodiment, resource orchestrator 712 may include a software design infrastructure ("SDI") management entity for data center 700. In at least one embodiment, resource orchestrator may include hardware, software or some combination thereof.

In at least one embodiment, as shown in FIG. 7, framework layer 720 includes a job scheduler 722, a configuration manager 724, a resource manager 726 and a distributed file system 728. In at least one embodiment, framework layer 720 may include a framework to support software 732 of software layer 730 and/or one or more application(s) 742 of application layer 740. In at least one embodiment, software 732 or application(s) 742 may respectively include web-based service software or applications, such as those provided by Amazon Web Services, Google Cloud and Microsoft Azure. In at least one embodiment, framework layer 720 may be, but is not limited to, a type of free and open-source software web application framework such as Apache Spark^{™} (hereinafter "Spark") that may use distributed file system 728 for large-scale data processing (e.g., "big data"). In at least one embodiment, job scheduler 722 may include a Spark driver to facilitate scheduling of workloads supported by various layers of data center 700. In at least one embodiment, configuration manager 724 may be capable of configuring different layers such as software layer 730 and framework layer 720 including Spark and distributed file system 728 for supporting large-scale data processing. In at least one embodiment, resource manager 726 may be capable of managing clustered or grouped computing resources mapped to or allocated for support of distributed file system 728 and job scheduler 722. In at least one embodiment, clustered or grouped computing resources may include grouped computing resource 714 at data center infrastructure layer 710. In at least one embodiment, resource manager 726 may coordinate with resource orchestrator 712 to manage these mapped or allocated computing resources.

In at least one embodiment, software 732 included in software layer 730 may include software used by at least portions of node C.R.s 716(1)-716(N), grouped computing resources 714, and/or distributed file system 728 of framework layer 720. The one or more types of software may include, but are not limited to, Internet web page search software, e-mail virus scan software, database software, and streaming video content software.

In at least one embodiment, application(s) 742 included in application layer 740 may include one or more types of applications used by at least portions of node C.R.s 716(1)-716(N), grouped computing resources 714, and/or distributed file system 728 of framework layer 720. One or more types of applications may include, but are not limited to, any number of a genomics application, a cognitive compute, and a machine learning application, including training or inferencing software, machine learning framework software (e.g., PyTorch, TensorFlow, Caffe, etc.) or other machine learning applications used in conjunction with one or more embodiments.

In at least one embodiment, any of configuration manager 724, resource manager 726, and resource orchestrator 712 may implement any number and type of self-modifying actions based on any amount and type of data acquired in any technically feasible fashion. In at least one embodiment, self-modifying actions may relieve a data center operator of data center 700 from making possibly bad configuration decisions and possibly avoiding underused and/or poor performing portions of a data center.

In at least one embodiment, data center 700 may include tools, services, software or other resources to train one or more machine learning models or predict or infer information using one or more machine learning models according to one or more embodiments described herein. For example, in at least one embodiment, a machine learning model may be trained by calculating weight parameters according to a neural network architecture using software and computing resources described above with respect to data center 700. In at least one embodiment, trained machine learning models corresponding to one or more neural networks may be used to infer or predict information using resources described above with respect to data center 700 by using weight parameters calculated through one or more training techniques described herein.

In at least one embodiment, a data center may use CPUs, application-specific integrated circuits (ASICs), GPUs, FPGAs, DPUs, QPUs, a plurality of parallel processing units (PPUs), or other hardware to perform training and/or inferencing using above-described resources. Moreover, one or more software and/or hardware resources described above may be configured as a service to allow users to train or perform inferencing of information, such as image recognition, speech recognition, or other artificial intelligence services.

Inference and/or training logic 715 are used to perform inferencing and/or training operations associated with one or more embodiments. In at least one embodiment, inference and/or training logic 715 may be used in system FIG. 7 for inferencing or predicting operations based, at least in part, on weight parameters calculated using neural network training operations, neural network functions and/or architectures, or neural network use cases described herein.

Such components can be used in data centers that use cooling loops as described herein.

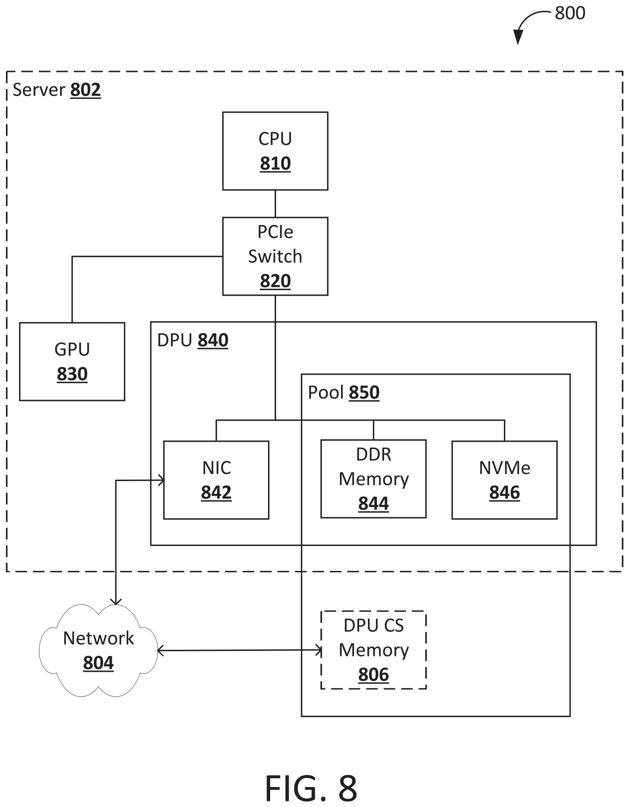

FIG. 8 illustrates an example computing environment 800 in which forward pass offloading to available memory can be performed, in accordance with at least one embodiment. It should be appreciated that embodiments of the present disclosure may also be used with reference to alternative environments and that specific discussion of components may be provided by way of non-limiting example and may include equivalents. Moreover, various features have been removed for clarity and conciseness. Additionally, systems and methods may be used with a variety of different architectures. The example computing environment 800 may include a server 802 which may be used to perform HPC workloads, such as AI training or machine learning model training. In an embodiment, the server 802 may be an application instance or a compute node. The server 802 may include a CPU 810 associated with a switch 820, such as a peripheral component interconnect express (PCIe) switch, which may control at least some data transmission over communication paths interconnecting various components. In an embodiment, the CPU 810 may include a root complex processor.

The PCIe switch 820 may also be associated with a GPU 830 and a DPU 840, and may transmit data between at least some of the CPU 810, the GPU 830, the DPU 840, and other components. In an embodiment, the PCIe switch 820 may be associated with more than one GPU or more than one DPU. In another embodiment, the PCIe switch 820 may be located within the DPU 840. The PCIe switch 820 may manage the transfer of at least some data between the CPU 810, the GPU 830, and the DPU 840. In another embodiment, the number of GPUs associated with the PCIe switch 820 may be equal to the number of DPUs associated with the PCIe switch 820. In at least one embodiment, the server 802 may include, without limitation, any number of the CPUs 810, the PCIe switches 820, the GPUs 830, and/or the DPUs 840, in any combination. For example, in at least one embodiment, server 802 could include eight, sixteen, thirty-two, and/or more GPUs 830. In at least one embodiment, communication paths interconnecting various components, including but not limited to the CPU 810, the PCIe switch 820, the GPU 830, and the DPU 840, in FIG. 8 may be implemented using any suitable protocols, such as peripheral component interconnect (PCI) based protocols (e.g., PCIe), or other bus or point-to-point communication interfaces and/or protocol(s), such as NV-Link high-speed interconnect, or interconnect protocols.

The DPU 840 may include a network interface controller (NIC) 842, a DDR memory 844, and a non-volatile memory express (NVMe) device 846. The NIC 842 may be able to interface with a network 804, which may also interface with additional NVMe devices available to the DPU 840, such as over fabric. In an embodiment, the DPU 840 may not include the NVMe device 846. In another embodiment, the NVMe device 846 may be located on the server 802 and not on the DPU 840. In yet another embodiment, the computing environment 800 may include more than one of the NVMe device 846, such as a first NVMe device in the DPU 840 and a second first NVMe device on the server 802, and associated directly with the PCIe switch 820. In an embodiment, the DPU 840 may not include the DDR memory 844 and may include a computational storage services (CSS) in place of, or in addition to, the DDR memory 844. For example, computing environment 800 may include DPU computational storage (CS) memory 806 available to the DPU 840 as part of the CSS. The network 804 may be able to interface with the DPU CS memory 806 through the NIC 842, according to any suitable interface protocol, such as remote direct memory access (RDMA) over Ethernet, InfiniBand, Fiber Channel, etc.

The total memory of the computing environment 800 available for data storage may be expanded through the use of the DPU 840 on nodes of the system. The DPU 840 may have access to a pool 850 of memory already available to the server 802, such as double data rate (DDR) memory, on-board NVMe devices, NVMe devices over fabric, and CS. The pool 850 of memory may include at least one of the DDR memory 844, NVMe 846, and the DPU CS memory 806. The DPU 840 may also be able to access the available memory of other DPUs as part of the pool 850, and other DPUs may be able to access the available memory of DPU 840, such as the pool 850. This available memory can be accessed and utilized for data storage, without the addition of compute resources, such as compute nodes, which would be required using other solutions. The available pool 850 accessible to the DPU 840 may be provisioned for the server 802 to expand the total memory available for data storage, such as to reduce the data storage load on the CPU 810 or the GPU 830, which can instead increase the utilization of their memory for processing. For example, during training of an AI, the model states, residual states, activation functions, and checkpoints can be stored, or offloaded, on the pool 850 accessible to the DPU 840.

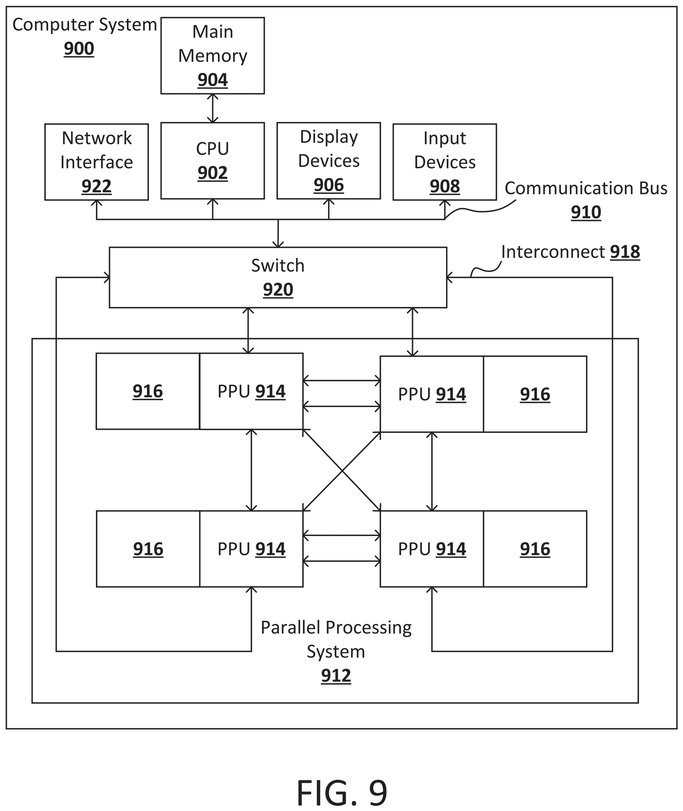

FIG. 9 illustrates a computer system 900, according to at least one embodiment. In at least one embodiment, computer system 900 is configured to implement various processes and methods described throughout this disclosure.

In at least one embodiment, computer system 900 comprises, without limitation, at least one central processing unit ("CPU") 902 that is connected to a communication bus 910 implemented using any suitable protocol, such as PCI ("Peripheral Component Interconnect"), peripheral component interconnect express ("PCI-Express"), AGP ("Accelerated Graphics Port"), HyperTransport, or any other bus or point-to-point communication protocol(s). In at least one embodiment, computer system 900 includes, without limitation, a main memory 904 and control logic (e.g., implemented as hardware, software, or a combination thereof) and data are stored in main memory 904 which may take form of random access memory ("RAM"). In at least one embodiment, a network interface subsystem ("network interface") 922 provides an interface to other computing devices and networks for receiving data from and transmitting data to other systems from computer system 900.

In at least one embodiment, computer system 900, in at least one embodiment, includes, without limitation, input devices 908, parallel processing system 912, and display devices 906 which can be implemented using a conventional cathode ray tube ("CRT"), liquid crystal display ("LCD"), light emitting diode ("LED"), plasma display, or other suitable display technologies. In at least one embodiment, user input is received from input devices 908 such as keyboard, mouse, touchpad, microphone, and more. In at least one embodiment, each of foregoing modules can be situated on a single semiconductor platform to form a processing system.

In at least one embodiment, computer programs in form of machine-readable executable code or computer control logic algorithms are stored in main memory 904 and/or secondary storage. Computer programs, if executed by one or more processors, enable system 900 to perform various functions in accordance with at least one embodiment. Memory 904, storage, and/or any other storage are possible examples of computer-readable media. In at least one embodiment, secondary storage may refer to any suitable storage device or system such as a hard disk drive and/or a removable storage drive, representing a floppy disk drive, a magnetic tape drive, a compact disk drive, digital versatile disk ("DVD") drive, recording device, universal serial bus ("USB") flash memory, etc. In at least one embodiment, architecture and/or functionality of various previous figures are implemented in context of CPU 902; parallel processing system 912; an integrated circuit capable of at least a portion of capabilities of both CPU 902; parallel processing system 912; a chipset (e.g., a group of integrated circuits designed to work and sold as a unit for performing related functions, etc.); and any suitable combination of integrated circuit(s).

In at least one embodiment, architecture and/or functionality of various previous figures are implemented in context of a general computer system, a circuit board system, a game console system dedicated for entertainment purposes, an application-specific system, and more. In at least one embodiment, computer system 900 may take form of a desktop computer, a laptop computer, a tablet computer, servers, supercomputers, a smart-phone (e.g., a wireless, hand-held device), personal digital assistant ("PDA"), a digital camera, a vehicle, a head mounted display, a hand-held electronic device, a mobile phone device, a television, workstation, game consoles, embedded system, and/or any other type of logic.

In at least one embodiment, parallel processing system 912 includes, without limitation, a plurality of parallel processing units ("PPUs") 914 and associated memories 916. In at least one embodiment, PPUs 914 are connected to a host processor or other peripheral devices via an interconnect 918 and a switch 920 or multiplexer. In at least one embodiment, parallel processing system 912 distributes computational tasks across PPUs 914 which can be parallelizable-for example, as part of distribution of computational tasks across multiple graphics processing unit ("GPU") thread blocks. In at least one embodiment, memory is shared and accessible (e.g., for read and/or write access) across some or all of PPUs 914, although such shared memory may incur performance penalties relative to use of local memory and registers resident to a PPU 914. In at least one embodiment, operation of PPUs 914 is synchronized through use of a command such as_syncthreads( ), wherein all threads in a block (e.g., executed across multiple PPUs 914) to reach a certain point of execution of code before proceeding.

Such components can be used in data centers that use cooling loops as described herein.

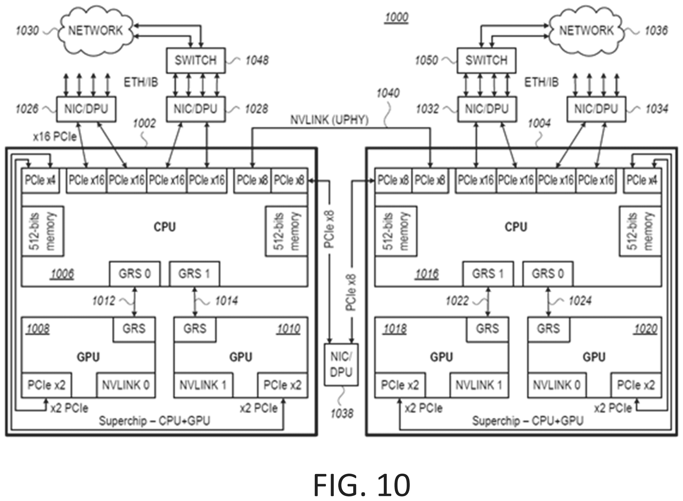

FIG. 10 is a block diagram that schematically illustrates a computing system 1000, e.g., a data center or a High-Performance Computing (HPC) cluster, in accordance with an embodiment that is described herein. System 1000 comprises a plurality of subsystems, e.g., multiple processing devices coupled to each other, multiple network devices, and multiple networks, according to at least one embodiment. Computing system 1000 is designed with multiple integrated circuits (referred to as processing devices), where each integrated circuit can include one or more CPUs and GPUs, forming a powerful and flexible architecture.

The various processing devices are interconnected via an NVLink or other high-speed interconnect, enabling high-speed communication between the subsystems, and are also connected through a NIC or DPU to ensure efficient data transfer across computing system 1000 and to one or more external networks 1030, 1036. In the present example, system 1000 comprises a switch 1048 that connects NIC/DPU 1028 to network 1030, and a packet switch 1050 that connects NIC/DPU 1032 to network 1036.

The coupling of processing devices through NVLink allows for seamless data exchange and parallel processing, enhancing overall computational performance. The processing devices are connected to multiple networks through one or more network interface controllers (NICs) or DPUs, enabling the system to handle complex, multi-network tasks with high bandwidth and low latency. This configuration is highly suitable for demanding applications that require significant processing power, such as artificial intelligence (AI), machine learning (ML), and data-intensive computing, while ensuring robust connectivity and scalability across various networked environments. The integrated circuits of the computing system 1000 can include one or more CPUs and one or more GPUs.

FIG. 10 also demonstrates an example architecture of a multi-GPU architecture. As illustrated in the figure, computing system 1000 includes a processing device 1002 with a multi-GPU architecture. In particular, processing device 1002 may be a system-on-chip and includes multiple subsystems such as a CPU 1006, a GPU 1008, and a GPU 1010. CPU 1006 can be coupled to GPU 1008 via a die-to-die (D2D) or chip-to-chip (C2C) interconnect 1012, such as a Ground-Referenced Signaling interconnect (GRS interconnect). CPU 1006 can be coupled to GPU 1010 via a D2D or C2C interconnect 1014. CPU 1006 can also couple to GPU 1008 and GPU 1010 via PCIe interconnects.

CPU 1006 can be coupled to one or more NICs or DPUs, which are coupled to one or more networks. For example, as illustrated in FIG. 10, CPU 1006 is coupled to a first NIC/DPU 1026, which is coupled to a network 1030. CPU 1006 is also coupled to a second NIC/DPU 1028, which is coupled to network 1030 via switch 1048. NIC/DPU 1026 and NIC/DPU 1028 can be coupled to network 1030 over Ethernet (ETH), NVLINK or InfiniBand (IB) connections, for example.

Computing system 1000 also includes a processing device 1004 with a multi-GPU architecture. In particular, processing device 1004 includes multiple subsystems including a CPU 1016, a GPU 1018, and a GPU 1020. CPU 1016 can be coupled to GPU 1018 via a D2D or C2C interconnect 1022. CPU 1016 can be coupled to GPU 1020 via a D2D or C2C interconnect 1024. CPU 1016 can also couple to GPU 1018 and GPU 1020 via PCIe interconnects. CPU 1016 can be coupled to one or more NICs or DPUs, which are coupled to one or more networks. For example, as illustrated in FIG. 10, CPU 1016 is coupled to a first NIC/DPU 1032, which is coupled to a network 1036. CPU 1016 is also coupled to a second NIC/DPU 1034, which is coupled to network 1036 via switch 1050. NIC/DPU 1032 and NIC/DPU 1034 can be coupled to network 1036 over Ethernet (ETH), NVLINK or InfiniBand (IB) connections.

In at least one embodiment, processing device 1002 and processing device 1004 can communicate with each other via a NIC/DPU 1038, such as over PCIe interconnects. Processing device 1002 and processing device 1004 can also communicate with each other over a high-bandwidth communication interconnects 1040, such as an NVLink interconnect or other high-speed interconnects. The packet switches in FIG. 10 may comprise, for example, Nvidia Quantum-2 switches. The NICs/DPUs in the figure may comprise, for example, Nvidia Bluefield DPUs.

In various embodiments, any of the network devices of system 1000, e.g., any of NICs/DPUs 1026, 1028, 1032, 1034 and 1038, and/or any of switches 1048 and 1050, may use ILI packets in accordance with the techniques described herein. Such components can be used in data centers that use liquid cooling systems.

In example embodiments, the heat-generating element may be a silicon photonics element (e.g., SiPh die) or photonic IC. The elements may be Co-packaged forming a multichip-module (MCM) assembly.

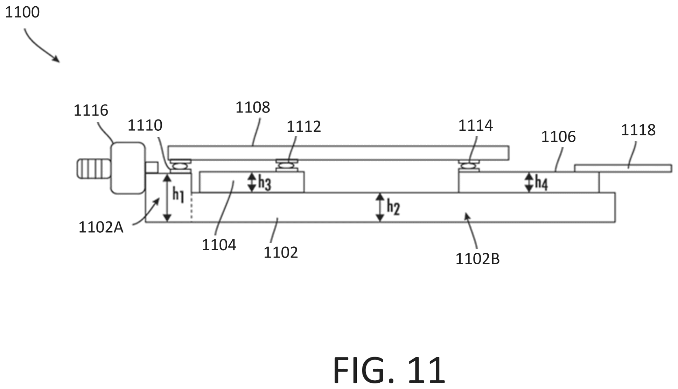

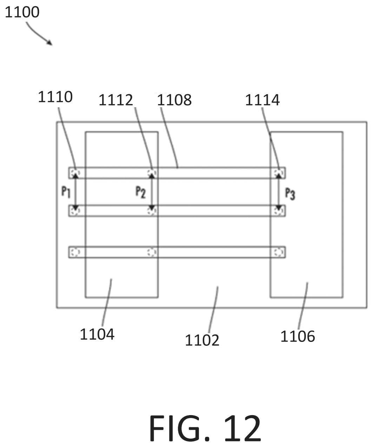

With reference to FIGS. 11 and 12, a cross-sectional view and a top plan view, respectively, of an optoelectronic component 1100 are illustrated. In some embodiments, the optoelectronic component 1100 may include a substrate 1102. The substrate 1102, for example, may be a printed circuit board, a metal carrier, an organic carrier, and/or a ceramic carrier. In some embodiments, the height of the substrate 1102 may vary. In this regard, for example, a first portion 1102A of the substrate 1102 may have a height h1 and a second portion 1102B of the substrate 1102 may have a height h2. In some embodiments, an electronic integrated circuit 1104 may be supported by the substrate 1102. The electronic integrated circuit 1104 may be any type of electronic integrated circuit. For example, the electronic integrated circuit 1104 may be a digital signal processor, a modulator driver, and/or a transimpedance amplifier. In some embodiments, there may be more than one electronic integrated circuit supported by the substrate 1102. In some embodiments, the electronic integrated circuit 1104 may have a height h3. In some embodiments, the optoelectronic component 1100 may support more than one electronic integrated circuit. In some embodiments, a photonic integrated circuit 1106 may be supported by the substrate 1102. The photonic integrated circuit 1106 may be any type of photonic integrated circuit. For example, the photonic integrated circuit 1106 may be an electro-optic modulator, a photodiode, a transmitter optical sub assembly and/or a receiver optical sub assembly. In some embodiments, the photonic integrated circuit 1106 may comprise graphene. In some embodiments, there may be more than one photonic integrated circuit supported by the substrate 1102. In some embodiments, the photonic integrated circuit 1106 may have a height h4. In some embodiments, the heights h1, h2, h3, and h4 may be different. For example, depending on the electronic integrated circuit and photonic integrated circuit used, the height h3 may be greater than the height h4, or vice versa.

In some embodiments, the optoelectronic component 1100 may include one or more optical fibers 1118 connected to the photonic integrated circuit 1106. The one or more optical fibers 1118 may be configured to connect the optoelectronic component 1100 to other optical components and/or devices. In some embodiments, a port 1116 may be connected to the substrate 1102. The port 1116 may be configured to connect the optoelectronic component 1100 to other electronic components and/or devices. In some embodiments, the optoelectronic component 1100 may be configured to operate at speeds greater than 25 Gb/s.

The optoelectronic component 1100 may include a plurality of substrate interconnect connectors 1110 disposed on the substrate 1102, a plurality of electronic integrated circuit interconnect connectors 1112 disposed on the electronic integrated circuit 1104, and a plurality of photonic integrated circuit interconnect connectors 1114 disposed on the photonic integrated circuit 1106. The plurality of substrate interconnect connectors 1110, the plurality of electronic integrated circuit interconnect connectors 1112, and the plurality of photonic integrated circuit interconnect connectors 1114 may comprise any conductive material (e.g., conductive glue and/or solder). In some embodiments, the plurality of substrate interconnect connectors 1110, the plurality of electronic integrated circuit interconnect connectors 1112, and the plurality of photonic integrated circuit interconnect connectors 1114 may be flexible. In other words, in some embodiments, the plurality of substrate interconnect connectors 1110, the plurality of electronic integrated circuit interconnect connectors 1112, and the plurality of photonic integrated circuit interconnect connectors 1114 may be manipulated such that each may be capable of taking various shapes. In some embodiments, the plurality of substrate interconnect connectors 1110 may have a pitch p1, the plurality of electronic integrated circuit interconnect connectors 1112 may have a pitch p2, and the plurality of photonic integrated circuit interconnect connectors 1114 may have a pitch p3. The pitch may refer to the distance between each of the plurality of interconnect connectors. In some embodiments, the pitch p1, pitch p2, pitch p3, may be different. For example, the pitch p2 of the plurality of electronic integrated circuit interconnect connectors 1112 may be 1.25 mm while the pitch p3 of the plurality of photonic integrated circuits may be 1.5 mm.

In some embodiments, the optoelectronic component 1100 may include a first plurality of cable connectors 1108. In some embodiments, each of the first plurality of cable connectors 1108 may be connected to and in communication with the substrate 1102, the electronic integrated circuit 1104, and the photonic integrated circuit 1106 via respective interconnect connectors. In other words, the first plurality of cable connectors 1108 may be connected to and in communication with the substrate 1102 via the plurality of substrate interconnect connectors 1110, the electronic integrated circuit 1104 via the plurality of electronic integrated circuit interconnect connectors 1112, and the photonic integrated circuit 1106 via the plurality of photonic integrated circuit interconnect connectors 1114. As such, the first plurality of cable connectors 1108 may be used to facilitate communication between the substrate 1102, the electronic integrated circuit 1104, and the photonic integrated circuit 1106.

In some embodiments, the first plurality of cable connectors 1108 may define a first layout. In some embodiments, the first layout may define the overall connectivity of the optoelectronic component 1100.

In some embodiments, the optoelectronic component 1100 may include a substrate 1102. The substrate 1102, for example, may be a printed circuit board, a metal carrier, an organic carrier, and/or a ceramic carrier.

The electronic integrated circuit 1104 may be any type of electronic integrated circuit. For example, the electronic integrated circuit 1104 may be a digital signal processor, a modulator driver, and/or a transimpedance amplifier. In some embodiments, there may be more than one electronic integrated circuit supported by the substrate 1102.

In some embodiments, a photonic integrated circuit 1106 may be supported by the substrate 1102. The photonic integrated circuit 1106 may be any type of photonic integrated circuit. For example, the photonic integrated circuit 1106 may be an electro-optic modulator, a photodiode, a transmitter optical sub assembly and/or a receiver optical sub assembly.

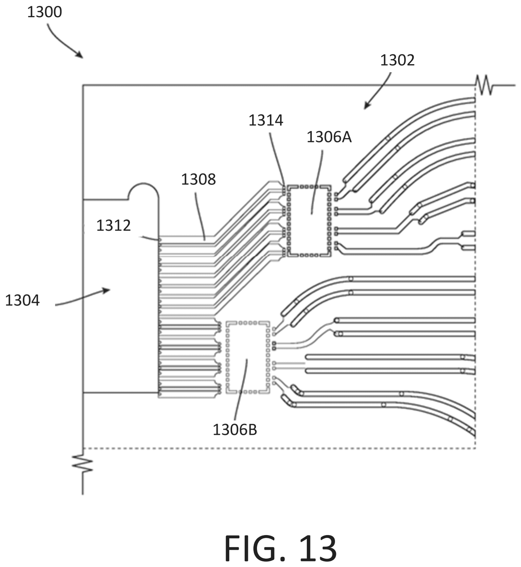

For example, with reference to FIG. 13, the connectivity defined by the first layout in the illustrated example is such that an electronic integrated circuit 1304 is connected to a first photonic integrated circuit 1306A and a second photonic integrated circuit 1306B via cable connectors 1308. In some embodiments, the first plurality of cable connectors 1108 may be interchangeable with other pluralities of cable connectors that define different layouts. The different layouts may alter the overall connectivity of the optoelectronic component 1100. For example, the first plurality of cable connectors 1108 may be interchangeable with a second plurality of cable connectors that define a second layout which modifies the overall connectivity of the optoelectronic component 1100. In this way, the optoelectronic component 1100 may be easily modified to obtain desired capabilities by interchanging cable connectors.

In some embodiments, the first plurality of cable connectors 1108 may be flexible. This may help ensure that the first plurality of cable connectors 1108 may be used with a variety of substrates, electronic integrated circuits, and photonic integrated circuits. For example, the substrate, electronic integrated circuit, and/or photonic integrated circuit may be from different manufacturers, may be a different type of integrated circuit or substrate, and/or may have different capabilities. For example, the substrate 1102, electronic integrated circuit 1104, and the photonic integrated circuit 1106 may have different heights (e.g., height h3 of the electronic integrated circuit 1104 may be greater than height h4 of the photonic integrated circuit 1106). The flexibility of the first plurality of cable connectors 1108 enables the first plurality of cable connectors 1108 to bend as needed, such that components of the optoelectronic component 1100 with different heights may be accommodated and connections may be made without any modifications to the configuration of the optoelectronic component 1100 itself. Additionally, the flexibility of the first plurality of cable connectors 1108 may enable the first plurality of cable connectors 1108 to be used with a variety of substrates, electronic integrated circuits, and photonic integrated circuits that have interconnect connectors with different pitches. For example, if the pitch p2 of the plurality of electronic integrated circuit interconnect connectors 1112 is less than the pitch p3 of the plurality of photonic integrated circuit interconnect connectors 1114, the first plurality of cable connectors 1108 may bend to account for the differences in pitch and connect the electronic integrated circuit 1104 to the photonic integrated circuit 1106.

With reference to FIG. 13, a portion of an example optoelectronic component 1300 is illustrated. For example, the example optoelectronic component 1300 may be part of a 1.6 Tb/s demonstrator. The example optoelectronic component 1300 includes a substrate 1302, an electronic integrated circuit 1304 supported by the substrate 1302, a first photonic integrated circuit 1306A supported by the substrate 1302, and a second photonic integrated circuit 1306B supported by the substrate 1302. The example optoelectronic component 1300 may include a plurality of electronic integrated circuit interconnect connectors 1312 disposed on the electronic integrated circuit 1304 and a plurality of photonic integrated circuit interconnect connectors 1314 disposed on the first photonic integrated circuit 1306A and the second photonic integrated circuit 1306B. The electronic integrated circuit 1304 may be connected to and in communication with the first photonic integrated circuit 1306A and the second photonic integrated circuit 1306B via a plurality of cable connectors 1308. In the example optoelectronic component 1300, the electronic integrated circuit 1304 and the first photonic integrated circuit 1306A are situated on the substrate 1302 such that the plurality of electronic integrated circuit interconnect connectors 1312 and the plurality of photonic integrated circuit interconnect connectors 1314 disposed on the first photonic integrated circuit 1306A are not aligned with each other (e.g., one is not disposed directly opposite to the other). In such a situation, the flexibility of the plurality of cable connectors 1308 facilitating communication between the electronic integrated circuit 1304 and the first photonic integrated circuit 1306A may allow the electronic integrated circuit 1304 and the first photonic integrated circuit 1306A to be connected through manipulation of the cable connectors to accommodate the misaligned locations.

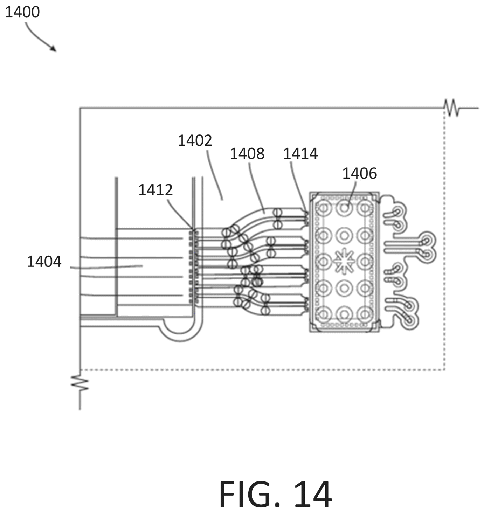

With reference to FIG. 14, another example optoelectronic component 1400 is illustrated. For example, the example optoelectronic component 1400 may be part of an octal small form factor pluggable (OSFP) transceiver. The example optoelectronic component 1400 includes a substrate 1402, an electronic integrated circuit 1404 supported by the substrate 1402, and a photonic integrated circuit 1406 supported by the substrate 1402. The example optoelectronic component 1400 may include a plurality of electronic integrated circuit interconnect connectors 1412 disposed on the electronic integrated circuit 1404 and a plurality of photonic integrated circuit interconnect connectors 1414 disposed on the photonic integrated circuit 1406. The electronic integrated circuit 1404 may be connected to and in communication with the photonic integrated circuit 1406 via a plurality of cable connectors 1408. In the example optoelectronic component 1400, the pitch of the plurality of the electronic integrated circuit interconnect connectors 1412 and the plurality of photonic integrated circuit interconnect connectors 1414 is different. In this case, the flexibility of the plurality of cable connectors 1408 facilitating communication between the electronic integrated circuit 1404 and the photonic integrated circuit 1406 may be such that the electronic integrated circuit 1404 and the photonic integrated circuit 1406 can be connected despite the differences in pitch, such as through bending or other reshaping of the cable connectors to accommodate the differences.

Silicon Photonics (SiP) is a technology that enables optical systems to be manufactured using silicon processes with silicon as the optical medium. Various optical components, such as interconnects and signal processing components, may be fabricated and integrated in a single SiP device. Some SiP devices are fabricated on a silica substrate or over a silica layer on a silicon substrate, a technology that is often referred to as Silicon on Insulator (SOI). In certain optical systems, a SiP device is attached to an external device to facilitate optical communications. However, it is generally difficult to accurately align light signals on the SiP with an external device that receives the light.

In certain optical systems, a SiP device is attached to an external device to facilitate optical communications. However, it is generally difficult to accurately align light signals on the SiP with an external device that receives the light. For instance, long range transmission of light signals is generally performed within optical fibers. When optical signals are generated or processed in a SiP device for transmission over optical fibers, the light needs to be coupled between the SiP device and the optical fibers. This coupling between the SiP device and the optical fibers is generally difficult because waveguides within the SiP device generally comprise a smaller diameter than the optical fibers. As such, a "world-to-chip" interface problem often arises in SiP technologies where coupling of light between Si wire waveguides and optical fibers, and vice versa, is generally inefficient.

Traditionally, for fiber-to-chip coupling, a fiber coupling technique using spot-size converters (SSCs) or grating couplers is employed. However, grating couplers for fiber-to-chip coupling typically provide a narrow bandwidth and/or an undesirable polarization sensitivity for certain optical applications. Furthermore, SSCs and grating couplers for fiber-to-chip coupling are generally attached to the chip through an adhesive bonding technique that results in a silicon communication chip with bundles of fibers attached thereto, resulting in increased complexity for handling and/or assembly of the chips onto other optical systems. Additionally, wafers for traditional SiP devices are generally diced (e.g., fully cut through) to create an edge for the wafer to expose waveguide facets and/or to facilitate butt attachment of the SiP device to an external device. Co-packaging may refer to the close integration of different electrical and/or optoelectronic chips in the same package.

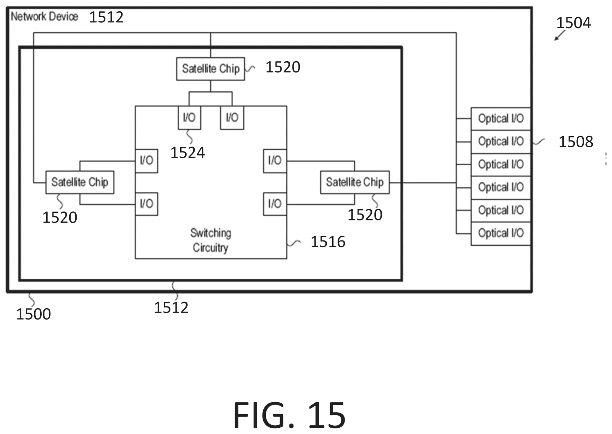

FIG. 15 is a block diagram that schematically illustrates a co-packaged Networking Device 1500, in accordance with an embodiment that is disclosed herein. The different chips that constitute a co-packaged Networking Device are assembled on a single substrate in what is typically called the MCM assembly 1512. The MCM assembly 1512 can include a switching circuitry 1516 surrounded by peripheral or satellite chips 1520. In some embodiments, the switching circuitry 1516 and surrounding satellite chips 1520 are all mounted on a common substrate, although such a configuration is not required. The MCM assembly 1512 may be provided in a larger housing of the co-packaged Networking Device 1500, positioned behind the front panel 1504. The switching circuitry 1516 may include one or more core digital Application Specific Integrated Circuits (ASICs), CPUs, GPUs, microprocessors, FPGAs, combinations thereof, and the like. The switching circuitry 1516 may include a number of input ports and/or output ports 1524. The Input/Output (I/O) ports 1524 may include electrical ports and/or optical ports. Additionally, the switching circuitry 1516 may include a combination of electrical blocks and optical blocks. The electrical blocks of the switching circuitry 1516 may include a number of electrical switches that are configured to route signals in an electrical domain. The optical blocks of the switching circuitry 1516 may include a number of optical components that are configured to generate, detect and route signals in an optical domain. The MCM assembly 1512, in some embodiments, may concern or include multiple satellite chips 1520 that are assembled on the same substrate as the switching circuitry 1516. In some embodiments, a configuration of the optical block(s) and a configuration of the electrical block(s) depends (e.g., is based on) on the number of optical ports in the I/O ports 1524.

As discussed above, optical I/Os 1508, which may also be referred to as optical connectors, are placed at the front panel 1504. As mentioned above, connectivity between the MCM assembly 1512 and optical I/Os 1508 may be transferred to the front panel 1504 through optical fibers. This connection may be made directly with an optical I/O port 1524 of the switching circuitry or may be made with one or more of the satellite chips 1520. The connection is often made with one or more of the satellite chips 1520 because the satellite chips 1520 may include the electro-optic converters and, possibly, the SERDES to natively support the connection. The satellite chips 1520 may include one or more of a DSP processor, driver, transimpedance amplifier, laser, modulator, photodiode, serializer-deserializer, or the like.

Some embodiments of the present disclosure are directed to a multi-chip module (MCM) with a centrally positioned main die and a plurality of peripherally positioned MCM sockets configured to mechanically receive and electrically connect mezzanine packages, which may include co-packaged optics (CPO) packages and co-packaged copper (CPC) packages. Each mezzanine package may include a package substrate including a connector portion that is configured to engage the MCM socket and a main portion extending beyond the periphery of the MCM substrate. The main portion of the mezzanine package may be configured to receive optical devices and/or integrated circuits, such as via mezzanine sockets, to allow connections to be made between the optical devices and/or integrated circuits/RF copper cable connectors and the main die of the MCM. Due to the extension of the mezzanine package beyond the periphery of the MCM substrate, the physical size of the MCM substrate may remain small to reduce cost and avoid the previously discussed production challenges, while allowing connections to a number of optical devices and integrated circuits via the mezzanine packages, which occupy the relatively inexpensive space around the periphery of the MCM substrate. As used herein, the terms "co-packaged optic" (or "CPO") and "co-packaged copper" (or "CPC") may refer to an advanced heterogeneous integration of either optics and silicon or copper and silicon, in which either integration may be implemented on a single packaged substrate. The CPO may utilize pluggable optical modules that include an optical engine (OE) to convert optical signals to electrical signals and electrical signals to optical signals. The CPO may further be comprised of an optical component on a photonics die and an electrical component on an electrical die.

As used herein, a ball grid array (BGA) may be a type of surface-mount packaging used for integrated circuits. BGA packages use an array of metallic conductor balls arranged in a grid to permanently mount devices such as microprocessors on a PCB. The metallic conductor balls may then undergo the reflow process described above, wherein the metallic conductor balls may be preheated, then melted to bond the IC to a substrate to form an IC package.

As used herein, the term "flip chip (FC)" may refer to a method for interconnecting dies, such as semiconductor devices, IC chips, integrated passive devices, and microelectromechanical systems (MEMS), to external circuitry with solder bumps that have been deposited onto chip pads. The solder bumps may be deposited onto chip pads on the top side of the wafer during final wafer processing. The chip may be mounted to external circuitry (such as a circuit board or another chip or wafer) by "flipping" the chip, such that the chip's top side faces down and is positioned to allow the pads of the chip to align with matching pads on the external circuit. Solder is reflowed to complete the interconnect.

In the packaging of integrated circuit (IC) chips, various packaging schemes are employed, including traditional two-dimensional (2D) integrated circuit (IC) packages as well as the more recently introduced 2.5D IC and 3D IC packages. In 2D IC packages, multiple chips are mounted on a printed circuit board, where high-performance logic, lower-performance logic, memory, and analog/RF functions, and other functional elements are presented as discrete devices in separate chip packages. By contrast, in 2.5D ICs and 3D IC packages, multiple IC chips are mounted on a silicon interposer instead of a conventional package substrate. The silicon interposer, which is typically a silicon wafer, allows very small and high-density conductive traces to be formed between the multiple IC chips because the fabrication processes used to form the conductive traces are the same processes used to form the metal interconnects in the metalization layers of a silicon chip.

Compared to 2.5D IC packages and 3D IC packages, a circuit board with individually packaged chips, such as a 2D IC package, has numerous disadvantages. For example, a 2D IC package is generally larger, heavier, consumes more power, and, because the signals propagate relatively slowly across the circuit board from one chip to another, is slower than an equivalent 2.5D or 3D IC package. Furthermore, a 2D IC package has more possible points of failure, given that the soldered joints on the circuit board are more likely to fail than the electrical connections formed within an interposer. That said, troubleshooting a 2D IC package after the different chips have been mounted on the circuit board is relatively straightforward. In particular, the conductive traces carrying I/O signals between the various chips on the circuit board are easily accessible and therefore can be employed to measure specific I/O signals during troubleshooting.

By contrast, troubleshooting a 2.5D or 3D IC package is far more problematic because the I/O signals transmitted between the different chips typically are embedded in the silicon interposer and are not physically accessible. Furthermore, because 2.5D and 3D IC packages are high-bandwidth and are quite dense, typically implementations can include thousands of conductive traces routed between the different chips. One example of such an implementation is a memory bus residing in between a processor and a high-bandwidth memory chip. In such implementations, even if the traces could be physically accessed through the silicon interposer with a probe, the accurate and reliable selection of a specific conductive trace or combination of conductive traces for the purpose of troubleshooting the IC package would be very difficult, if not impossible.

In at least one embodiment, one or more parallel processor(s) incorporate circuitry optimized for graphics and video processing, including, for example, video output circuitry, and constitutes a graphics processing unit ("GPU"). In at least one embodiment, one or more parallel processor(s) incorporate circuitry optimized for general purpose processing. In at least one embodiment, components of computing system may be integrated with one or more other system elements on a single integrated circuit. For example, in at least one embodiment, one or more parallel processor(s), memory hub, processor(s), and I/O hub can be integrated into a SoC integrated circuit. In at least one embodiment, components of computing system can be integrated into a single package to form a system in package ("SIP") configuration. In at least one embodiment, at least a portion of components of computing system 300 can be integrated into a multi-chip module ("MCM"), which can be interconnected with other multi-chip modules into a modular computing system. In at least one embodiment, I/O subsystem and display devices are omitted from computing system.

When the light-transmitting medium is silicon, a suitable insulator includes, but is not limited to, silica and a suitable substrate includes a silicon substrate. A silicon-on-insulator wafer is a suitable platform for an optical device having a silicon light-transmitting medium positioned over a base having a silica insulator and a silicon substrate.

The device includes one or more waveguides that carry light signals to and/or from optical components. Examples of optical components that can be included on the device include, but are not limited to, one or more components selected from a group consisting of facets through which light signals can enter and/or exit a waveguide, entry/exit ports through which light signals can enter and/or exit a waveguide from above or below the device, multiplexers for combining multiple light signals onto a single waveguide, demultiplexers for separating multiple light signals such that different light signals are received on different waveguides, optical couplers, optical switches, lasers that act as a source of a light signal, amplifiers for amplifying the intensity of a light signal, attenuators for attenuating the intensity of a light signal, modulators for modulating a signal onto a light signal, modulators that convert a light signal to an electrical signal, and vias that provide an optical pathway for a light signal traveling through the device from the bottom side of the device to the top side of the device. Additionally, the device can optionally, include electrical components. For instance, the device can include electrical connections for applying a potential or current to a waveguide and/or for controlling other components on the optical device.

Various embodiments can be described by the following clauses:
1. An apparatus comprising:
   an inlet to receive a cooling fluid;
   a cooling loop to circulate the cooling fluid in a circular path around a central region of the apparatus, the cooling loop being proximate to one or more heat-generating elements; and
   an outlet to discharge the cooling fluid.
2. The apparatus of clause 1, further comprising one or more connecting elements to secure the apparatus to the one or more heat-generating elements.
3. The apparatus of clause 2, wherein the one or more connecting elements comprise at least one of screws, bolts, or fasteners.
4. The apparatus of clause 1, further comprising a spring mechanism to allow compliance between the apparatus and the one or more heat-generating elements.
5. The apparatus of clause 4, wherein the spring mechanism is to compensate for thermal expansion of the one or more heat-generating elements.
6. The apparatus of clause 1, further comprising a second cooling loop to receive the cooling fluid from the cooling loop, the second cooling loop being proximate to a cold plate located within the central region.
7. The apparatus of clause 1, further comprising one or more temperature sensors to:
   generate one or more temperature data corresponding to the one or more heat-generating elements; and
   transmit the temperature data to a controller.
8. The apparatus of clause 1, wherein the inlet is to receive cooling fluid at least from a cooling distribution unit (CDU) and the outlet is to discharge the cooling fluid to the CDU.
9. The apparatus of clause 1, wherein the one or more heat-generating elements comprise at least one of a central processing unit (CPU), a graphics processing unit (GPU), a quantum processing unit (QPU), an application specific integrated circuit (ASIC), or a printed circuit board (PCB).
10. A method comprising:
   providing a cooling apparatus having a cooling loop to circulate a cooling fluid proximate to one or more heat-generating elements in a circular path around a central region of the cooling apparatus;
   circulating the cooling fluid to the cooling loop to dissipate heat from the one or more heat-generating elements; and
   discharging the cooling fluid.
11. The method of clause 10, further comprising removably attaching the cooling apparatus to the one or more heat-generating elements.
12. The method of clause 10, further comprising circulating the cooling fluid from the cooling loop to a second cooling loop proximate to a cold plate in the central region.
13. The method of clause 10, comprising applying compressive force to the cooling apparatus via a spring mechanism to allow thermal contact between the cooling apparatus and the one or more heat-generating elements.
14. The method of clause 13, wherein the spring mechanism compensates for thermal expansion of the one or more heat-generating elements.
15. The method of clause 10, further comprising circulating the cooling fluid at a variable flow rate based at least on a temperature of the one or more heat-generating components and a cold plate.
16. An apparatus comprising a cooling loop to circulate a cooling fluid proximate to a heat-generating element in a path surrounding a central region of the apparatus.
17. The apparatus of clause 16, further to circulate the cooling fluid at a variable flow rate based at least on thermal load of the heat-generating element and a cold plate.
18. The apparatus of clause 16, further comprising a second cooling loop to receive the cooling fluid from the cooling loop and to circulate the cooling fluid proximate to a cold plate in the central region.
19. The apparatus of clause 16, wherein the heat-generating element comprises at least one of a central processing unit (CPU), a graphics processing unit (GPU), a quantum processing unit (QPU), an application specific integrated circuit (ASIC), or a printed circuit board (PCB).
20. The apparatus of clause 16, further comprising a spring mechanism to allow compliance between the apparatus and the heat-generating element.
21. The apparatus of clause 16, wherein the cooling loop circulates the cooling fluid on top of the heat-generating element.

Other variations are within spirit of present disclosure. Thus, while disclosed techniques are susceptible to various modifications and alternative constructions, certain illustrated embodiments thereof are shown in drawings and have been described above in detail. It should be understood, however, that there is no intention to limit disclosure to specific form or forms disclosed, but on contrary, intention is to cover all modifications, alternative constructions, and equivalents falling within spirit and scope of disclosure, as defined in appended claims.

Use of terms "a" and "an" and "the" and similar referents in context of describing disclosed embodiments (especially in context of following claims) are to be construed to cover both singular and plural, unless otherwise indicated herein or clearly contradicted by context, and not as a definition of a term. Terms "comprising," "having," "including," and "containing" are to be construed as open-ended terms (meaning "including, but not limited to,") unless otherwise noted. "Connected," when unmodified and referring to physical connections, is to be construed as partly or wholly contained within, attached to, or joined together, even if there is something intervening. Recitation of ranges of values herein are merely intended to serve as a shorthand method of referring individually to each separate value falling within range, unless otherwise indicated herein and each separate value is incorporated into specification as if it were individually recited herein. In at least one embodiment, use of term "set" (e.g., "a set of items") or "subset" unless otherwise noted or contradicted by context, is to be construed as a nonempty collection comprising one or more members. Further, unless otherwise noted or contradicted by context, term "subset" of a corresponding set does not necessarily denote a proper subset of corresponding set, but subset and corresponding set may be equal.

Conjunctive language, such as phrases of form "at least one of A, B, and C," or "at least one of A, B and C," unless specifically stated otherwise or otherwise clearly contradicted by context, is otherwise understood with context as used in general to present that an item, term, etc., may be either A or B or C, or any nonempty subset of set of A and B and C. For instance, in illustrative example of a set having three members, conjunctive phrases "at least one of A, B, and C" and "at least one of A, B and C" refer to any of following sets: {A}, {B}, {C}, {A, B}, {A, C}, {B, C}, {A, B, C}. Thus, such conjunctive language is not generally intended to imply that certain embodiments require at least one of A, at least one of B and at least one of C each to be present. In addition, unless otherwise noted or contradicted by context, term "plurality" indicates a state of being plural (e.g., "a plurality of items" indicates multiple items). In at least one embodiment, number of items in a plurality is at least two, but can be more when so indicated either explicitly or by context. Further, unless stated otherwise or otherwise clear from context, phrase "based on" means "based at least in part on" and not "based solely on."

Operations of processes described herein can be performed in any suitable order unless otherwise indicated herein or otherwise clearly contradicted by context. In at least one embodiment, a process such as those processes described herein (or variations and/or combinations thereof) is performed under control of one or more computer systems configured with executable instructions and is implemented as code (e.g., executable instructions, one or more computer programs or one or more applications) executing collectively on one or more processors, by hardware or combinations thereof. In at least one embodiment, code is stored on a computer-readable storage medium, for example, in form of a computer program comprising a plurality of instructions executable by one or more processors. In at least one embodiment, a computer-readable storage medium is a non-transitory computer-readable storage medium that excludes transitory signals (e.g., a propagating transient electric or electromagnetic transmission) but includes non-transitory data storage circuitry (e.g., buffers, cache, and queues) within transceivers of transitory signals. In at least one embodiment, code (e.g., executable code or source code) is stored on a set of one or more non-transitory computer-readable storage media having stored thereon executable instructions (or other memory to store executable instructions) that, when executed (i.e., as a result of being executed) by one or more processors of a computer system, cause computer system to perform operations described herein. In at least one embodiment, set of non-transitory computer-readable storage media comprises multiple non-transitory computer-readable storage media and one or more of individual non-transitory storage media of multiple non-transitory computer-readable storage media lack all of code while multiple non-transitory computer-readable storage media collectively store all of code. In at least one embodiment, executable instructions are executed such that different instructions are executed by different processors - for example, a non-transitory computer-readable storage medium store instructions and a main central processing unit ("CPU") executes some of instructions while a graphics processing unit ("GPU") executes other instructions. In at least one embodiment, different components of a computer system have separate processors and different processors execute different subsets of instructions.

In at least one embodiment, an arithmetic logic unit is a set of combinational logic circuitry that takes one or more inputs to produce a result. In at least one embodiment, an arithmetic logic unit is used by a processor to implement mathematical operation such as addition, subtraction, or multiplication. In at least one embodiment, an arithmetic logic unit is used to implement logical operations such as logical AND/OR or XOR. In at least one embodiment, an arithmetic logic unit is stateless, and made from physical switching components such as semiconductor transistors arranged to form logical gates. In at least one embodiment, an arithmetic logic unit may operate internally as a stateful logic circuit with an associated clock. In at least one embodiment, an arithmetic logic unit may be constructed as an asynchronous logic circuit with an internal state not maintained in an associated register set. In at least one embodiment, an arithmetic logic unit is used by a processor to combine operands stored in one or more registers of the processor and produce an output that may be stored by the processor in another register or a memory location.

In at least one embodiment, as a result of processing an instruction retrieved by the processor, the processor presents one or more inputs or operands to an arithmetic logic unit, causing the arithmetic logic unit to produce a result based at least in part on an instruction code provided to inputs of the arithmetic logic unit. In at least one embodiment, the instruction codes provided by the processor to the ALU are based at least in part on the instruction executed by the processor. In at least one embodiment combinational logic in the ALU processes the inputs and produces an output which is placed on a bus within the processor. In at least one embodiment, the processor selects a destination register, memory location, output device, or output storage location on the output bus so that clocking the processor causes the results produced by the ALU to be sent to the desired location.

In the scope of this application, the term arithmetic logic unit, or ALU, is used to refer to any computational logic circuit that processes operands to produce a result. For example, in the present document, the term ALU may refer to a floating point unit, a DSP, a tensor core, a shader core, a coprocessor, or a CPU.

Accordingly, in at least one embodiment, computer systems are configured to implement one or more services that singly or collectively perform operations of processes described herein and such computer systems are configured with applicable hardware and/or software that enable performance of operations. Further, a computer system that implements at least one embodiment of present disclosure is a single device and, in another embodiment, is a distributed computer system comprising multiple devices that operate differently such that distributed computer system performs operations described herein and such that a single device does not perform all operations.

Use of any and all examples, or exemplary language (e.g., "such as") provided herein, is intended merely to better illuminate embodiments of disclosure and does not pose a limitation on scope of disclosure unless otherwise claimed. No language in specification should be construed as indicating any non-claimed element as essential to practice of disclosure.

In description and claims, terms "coupled" and "connected," along with their derivatives, may be used. It should be understood that these terms may be not intended as synonyms for each other. Rather, in particular examples, "connected" or "coupled" may be used to indicate that two or more elements are in direct or indirect physical or electrical contact with each other. "Coupled" may also mean that two or more elements are not in direct contact with each other, but yet still co-operate or interact with each other.

Unless specifically stated otherwise, it may be appreciated that throughout specification terms such as "processing," "computing," "calculating," "determining," or like, refer to action and/or processes of a computer or computing system, or similar electronic computing device, that manipulate and/or transform data represented as physical, such as electronic, quantities within computing system's registers and/or memories into other data similarly represented as physical quantities within computing system's memories, registers or other such information storage, transmission or display devices.

In a similar manner, term "processor" may refer to any device or portion of a device that processes electronic data from registers and/or memory and transform that electronic data into other electronic data that may be stored in registers and/or memory. As non-limiting examples, "processor" may be a CPU or a GPU. A "computing platform" may comprise one or more processors. As used herein, "software" processes may include, for example, software and/or hardware entities that perform work over time, such as tasks, threads, and intelligent agents. Also, each process may refer to multiple processes, for carrying out instructions in sequence or in parallel, continuously or intermittently. In at least one embodiment, terms "system" and "method" are used herein interchangeably insofar as system may embody one or more methods and methods may be considered a system.

In present document, references may be made to obtaining, acquiring, receiving, or inputting analog or digital data into a subsystem, computer system, or computer-implemented machine. In at least one embodiment, process of obtaining, acquiring, receiving, or inputting analog and digital data may be accomplished in a variety of ways such as by receiving data as a parameter of a function call or a call to an application programming interface. In at least one embodiment, processes of obtaining, acquiring, receiving, or inputting analog or digital data may be accomplished by transferring data via a serial or parallel interface. In at least one embodiment, processes of obtaining, acquiring, receiving, or inputting analog or digital data may be accomplished by transferring data via a computer network from providing entity to acquiring entity. In at least one embodiment, references may also be made to providing, outputting, transmitting, sending, or presenting analog or digital data. In various examples, processes of providing, outputting, transmitting, sending, or presenting analog or digital data may be accomplished by transferring data as an input or output parameter of a function call, a parameter of an application programming interface or interprocess communication mechanism.

Although descriptions herein set forth example implementations of described techniques, other architectures may be used to implement described functionality, and are intended to be within scope of this disclosure. Furthermore, although specific distributions of responsibilities may be defined above for purposes of description, various functions and responsibilities might be distributed and divided in different ways, depending on circumstances.

Furthermore, although subject matter has been described in language specific to structural features and/or methodological acts, it is to be understood that subject matter claimed in appended claims is not necessarily limited to specific features or acts described. Rather, specific features and acts are disclosed as exemplary forms of implementing the claims.

It will be understood that aspects and embodiments are described above purely by way of example, and that modifications of detail can be made within the scope of the claims.

Each apparatus, method, and feature disclosed in the description, and (where appropriate) the claims and drawings may be provided independently or in any appropriate combination.

Reference numerals appearing in the claims are by way of illustration only and shall have no limiting effect on the scope of the claims.

## Claims

1. An apparatus comprising:
an inlet to receive a cooling fluid;
a cooling loop to circulate the cooling fluid in a circular path around a central region of the apparatus, the cooling loop being proximate to one or more heat-generating elements; and
an outlet to discharge the cooling fluid.

2. The apparatus of claim 1, further comprising one or more connecting elements to secure the apparatus to the one or more heat-generating elements, wherein the one or more connecting elements comprise at least one of screws, bolts, or fasteners.

3. The apparatus of claim 1 or 2, further comprising a spring mechanism to allow compliance between the apparatus and the one or more heat-generating elements, wherein the spring mechanism is to compensate for thermal expansion of the one or more heat-generating elements.

4. The apparatus of claim 1, 2, or 3, further comprising a second cooling loop to receive the cooling fluid from the cooling loop, the second cooling loop being proximate to a cold plate located within the central region.

5. The apparatus of any of claims 1-4, further comprising one or more temperature sensors to:
generate one or more temperature data corresponding to the one or more heat-generating elements; and
transmit the temperature data to a controller.

6. The apparatus of any of claims 1-5, wherein the inlet is to receive cooling fluid at least from a cooling distribution unit (CDU) and the outlet is to discharge the cooling fluid to the CDU.

7. The apparatus of any of claims 1-6, wherein the one or more heat-generating elements comprise at least one of a central processing unit (CPU), a graphics processing unit (GPU), a quantum processing unit (QPU), an application specific integrated circuit (ASIC), or a printed circuit board (PCB).

8. A method comprising:
providing a cooling apparatus having a cooling loop to circulate a cooling fluid proximate to one or more heat-generating elements in a circular path around a central region of the cooling apparatus;
circulating the cooling fluid to the cooling loop to dissipate heat from the one or more heat-generating elements; and
discharging the cooling fluid.

9. The method of claim 8, further comprising removably attaching the cooling apparatus to the one or more heat-generating elements, applying compressive force to the cooling apparatus via a spring mechanism to allow thermal contact between the cooling apparatus and the one or more heat-generating elements, wherein the spring mechanism compensates for thermal expansion of the one or more heat-generating elements.

10. The method of claim 8 or 9, further comprising circulating the cooling fluid from the cooling loop to a second cooling loop proximate to a cold plate in the central region at a variable flow rate based at least on a temperature of the one or more heat-generating components and a cold plate.

11. An apparatus comprising a cooling loop to circulate a cooling fluid proximate to a heat-generating element in a path surrounding a central region of the apparatus.

12. The apparatus of claim 11, further to circulate the cooling fluid at a variable flow rate based at least on thermal load of the heat-generating element and a cold plate.

13. The apparatus of claim 11 or 12, further comprising a second cooling loop to receive the cooling fluid from the cooling loop and to circulate the cooling fluid proximate to a cold plate in the central region.

14. The apparatus of claim 11, 12, or 13, further comprising a spring mechanism to allow compliance between the apparatus and the heat-generating element.

15. The apparatus of any of claims 11-14, wherein the cooling loop circulates the cooling fluid on top of the heat-generating element.
